(19) **Europäisches Patentamt / European Patent Office / Office européen des brevets**

(11) **EP 4 529 400 A1**

(12) **EUROPEAN PATENT APPLICATION**
published in accordance with Art. 153(4) EPC

(43) Date of publication:
26.03.2025 Bulletin 2025/13

(21) Application number: 23807957.8

(22) Date of filing: 19.05.2023

(51) International Patent Classification (IPC):
$H10K\ 59/35^{(2023.01)}$    $H10K\ 50/814^{(2023.01)}$
$H10K\ 50/82^{(2023.01)}$    $H10K\ 50/844^{(2023.01)}$
$H10K\ 59/124^{(2023.01)}$    $H10K\ 59/123^{(2023.01)}$
$H10K\ 50/11^{(2023.01)}$    $H10K\ 50/13^{(2023.01)}$
$H10K\ 71/10^{(2023.01)}$

(52) Cooperative Patent Classification (CPC):
H10K 50/11; H10K 50/13; H10K 50/15;
H10K 50/18; H10K 50/814; H10K 50/82;
H10K 50/844; H10K 59/123; H10K 59/124;
H10K 59/35; H10K 59/80; H10K 71/10;
H10K 2101/10; H10K 2102/00

(86) International application number:
PCT/KR2023/006882

(87) International publication number:
WO 2023/224438 (23.11.2023 Gazette 2023/47)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 20.05.2022 KR 20220062083
22.11.2022 KR 20220157455

(71) Applicants:
• Yas Co., Ltd.
  Paju-si, Gyeonggi-do 10857 (KR)
• Ahn, Byungchul
  Seoul 06574 (KR)

(72) Inventor: AHN, Byungchul
Seoul 06574 (KR)

(74) Representative: Epping - Hermann - Fischer
Patentanwaltsgesellschaft mbH
Schloßschmidstraße 5
80639 München (DE)

(54) **ORGANIC LIGHT-EMITTING DISPLAY DEVICE**

(57) An organic light emitting display device can comprise a substrate, a plurality of stripe patterns on the substrate, a first organic light emitting device in a first subpixel, a second organic light emitting device in a second subpixel, and a third organic light emitting device in a third subpixel.

The first organic light emitting device can be disposed on a first area of the stripe pattern, the second organic light emitting device can be disposed on a second area of the stripe pattern, and the third organic light emitting device can be disposed on a separation area between the adjacent stripe patterns.

FIG. 3

EP 4 529 400 A1

**Description**

**BACKGROUND OF THE INVENTION**

**Field of the Invention**

An embodiment relates to an organic light emitting display device.

**2. Discussion of the Related Art**

Recently, flat panel display having excellent characteristics such as thinness, light weight, and low power consumption have been widely developed and applied to various fields.

Among flat panel display devices, an organic light emitting display device is a display device that emits light as electrons and holes form pairs by injecting charge into an organic light emitting layer formed between a second electrode, which is an electron injection electrode, and a first electrode, which is a hole injection electrode, and then they disappear.

A fine metal mask (FMM) is used as a pattern mask for deposition to deposit and form the organic light emitting layer constituting the organic light emitting device for each subpixel.

However, in manufacturing a high-definition (e.g., 500 PPI (pixel per inch) or higher) display device or a large-area (e.g., 8th generation or higher) display device, it is quite difficult to form a light emitting layer for each subpixel using FMM. In addition, when using the FMM, there is a limit to further increasing the high-definition.

In addition, when using the FMM, there is a problem that the yield is lowered and the manufacturing cost is increased.

In addition, when FMM is used, there is a problem in that product lifespan is reduced because it is difficult to optimize deposition.

**SUMMARY OF THE INVENTION**

An object of the embodiment is to provide an organic light emitting display device capable of effectively forming an emission layer without using a deposition pattern mask such as FMM.

According to one aspect of the embodiment, an organic light emitting display device, comprising: a substrate; a plurality of stripe patterns on the substrate; a first organic light emitting device in a first subpixel; a second organic light emitting device in a second subpixel; and a third organic light emitting device in a third subpixel, wherein the first organic light emitting device is disposed on a first area of the stripe pattern, wherein the second organic light emitting device is disposed on a second area of the stripe pattern, and wherein the third organic light emitting device is disposed on a separation area between the adjacent stripe patterns.

The first area of the stripe pattern can have a first inclined surface inclined with respect to the separation area, and the second area of the stripe pattern can have a second inclined surface inclined with respect to the separation area.

A first inclined angle of the first inclined surface and a second inclined angle of the second inclined surface can be equal to each other.

A first inclined angle of the first inclined surface and a second inclined angle of the second inclined surface can be different from each other.

The stripe pattern can have at least three or more surfaces, one of the at least three or more surfaces can be the first inclined surface, and the other surface of the at least three or more surfaces can be the second inclined surface.

The stripe pattern can have a shape symmetrical to each other with respect to the normal direction.

The stripe pattern can have a shape asymmetrical to each other with respect to the normal direction.

Each of the first inclined surface and the second inclined surface can have a flat or curved shape.

Each of the first to third organic light emitting devices can have a different light emission direction.

The first organic light emitting device to the third organic light emitting device can commonly comprise a third organic light emitting layer.

The first organic light emitting device can comprise a first organic light emitting layer on the third organic light emitting layer, and the second organic light emitting device can comprise a second organic light emitting layer on the third organic light emitting layer.

The first organic light emitting device, the second organic light emitting device, and the third organic light emitting device each can comprise a first electrode below the third organic light emitting layer, and the first electrode can be separately disposed in each of the separation area, the first area, and the second area.

The organic light emitting display device can further comprise a protective pattern covering the edge of the first electrode.

According to another aspect of the embodiment, an organic light emitting display device, comprising: a substrate;

a plurality of stripe patterns on the substrate; a first organic light emitting device in a first subpixel; a second organic light emitting device in a second subpixel; and a third organic light emitting device in a third subpixel, wherein the first organic light emitting device is disposed on a first area of the stripe pattern, wherein the second organic light emitting device is disposed on a second area of the stripe pattern, wherein the third organic light emitting device is disposed on a separation area between the adjacent stripe patterns, wherein the first to third organic light emitting devices commonly comprise a third organic light emitting layer, wherein the first organic light emitting device comprises a first organic light emitting layer on the third organic light emitting layer, wherein the second organic light emitting device comprises a second organic light emitting layer on the third organic light emitting layer, wherein the first organic light emitting layer of the first organic light emitting device, the second organic light emitting layer of the second organic light emitting device, and the third organic light emitting layer of the third organic light emitting device each has a different thickness.

The first organic light emitting device can comprise a first electron blocking layer between the first organic light emitting layer and the third organic light emitting layer, and the second organic light emitting device can comprise a second electron blocking layer between the second organic light emitting layer and the third organic light emitting layer.

The third organic light emitting device can comprise a third electron blocking layer on the third organic light emitting layer.

The first electron blocking layer to the third electron blocking layer each can have a different thickness.

The first electron blocking layer to the third electron blocking layer can have different thicknesses, and the third electron blocking layer may not exist.

The third organic light emitting layer of each of the first to third organic light emitting devices can have a different thickness.

The thickness of the third organic light emitting layer of the first organic light emitting device can be smaller than the thickness of the third organic light emitting layer of the third organic light emitting device.

The thickness of the third organic light emitting layer of the second organic light emitting device can be smaller than the thickness of the third organic light emitting layer of the third organic light emitting device.

The organic light emitting display device can satisfy Equation 5 below.

$$\text{Equation 5:} \quad \left| \text{EBL T1} - \text{Host T1} \right| \geq 0.2 \text{ eV}$$

EBL T1 can represent a triplet energy of a material of the first electron blocking layer in the first organic light emitting device or a triplet energy of a material of the second electron blocking layer in the second organic light emitting device.

Host T1 can represent a triplet energy of a host of the first organic light emitting layer in the first organic light emitting device or a triplet energy of a host of the second organic light emitting layer in the second organic light emitting device.

The first organic light emitting device, the second organic light emitting device, and the third organic light emitting device each can comprise a first organic light emitting layer and a second organic light emitting layer respectively below and above at least one or more charge generation layer.

The first organic light emitting device, the second organic light emitting device, and the third organic light emitting device each can comprise a first electron blocking layer below the first organic light emitting layer and a second electron blocking layer below the second organic light emitting layer and a third organic light emitting layer below each of the first electron blocking layer and the second blocking layer. At least one of the first electron blocking layer and the second electron blocking layer can have different thicknesses for the first subpixel, the second subpixel, and the third subpixel. In this case, the thickness of a first hole transport layer of the first subpixel and/or a second hole transport layer of the second subpixel can be smaller than that of a third hole transport layer of the third subpixel.

In the embodiment, two subpixels (a first subpixel and a second subpixel) constituting a pixel can be located on the first area (first inclined surface) and second area (second inclined surface) of the stripe pattern, another subpixel (third subpixel) can be located on a separation area between the adjacent stripe patterns. In this case, first to third organic light emitting layers corresponding to the first to third subpixels can be deposited. At this time, the first organic light emitting layer to the third organic light emitting layer can be deposited on the first subpixel to the third subpixel using a self-aligned method, respectively.

Accordingly, it is possible to form subpixels in a side-by-side structure for a high-definition or large-area display device that is difficult to manufacture with FMM, thereby improving performance of display device such as power consumption, luminance, lifespan, etc.

In addition, since a side-by-side structure can be implemented through an in-line deposition method, investment costs can be reduced and productivity can be improved (e.g., approximately 3 times or more).

In addition, since the light emitting layer can be formed without using FMM, the yield can be improved and the manufacturing cost can be reduced.

In addition, since the organic light emitting layer can be formed without using FMM, product lifespan can be extended through optimization of deposition.

In addition, the pixel can have a three-dimensional structure instead of a planar structure so that the light emitting area can be widened and the lifespan can be improved (e.g., about 4 times or more).

In addition, since it is implemented as a three-dimensional structure in which organic light emitting devices emitting at least two or more different color lights are disposed on at least two or more subpixels through a three-dimensional structure of a stripe pattern, compared to the existing planar structure, a further increased high-definition can be secured so that XR (extended reality)-related devices such as AR (augmented reality), VR (virtual reality), MR (mixed reality), etc. can be adopted.

## BRIEF DESCRIPTION OF THE DRAWINGS

FIG. 1 is a diagram schematically showing an organic light emitting display device according to a first embodiment.

FIG. 2 is a diagram schematically showing a stacked structure for each organic light emitting device according to the first embodiment.

FIG. 3 is a cross-sectional view schematically showing a stripe pattern and a light emitting layer according to a first embodiment.

FIGS. 4 to 6 are a diagram schematically showing deposition methods of a blue light emitting layer, a red light emitting layer, and a green light emitting layer according to a first embodiment, respectively.

FIG. 7 is a diagram schematically showing another example of a method of depositing a blue light emitting layer according to the first embodiment.

FIG. 8 is a diagram schematically showing a design structure of a stripe pattern and a design structure of a deposition apparatus according to the first embodiment.

FIG. 9 is a diagram showing an example of the structure of an organic light emitting display device according to the first embodiment.

FIGS. 10 and 11 are diagrams showing each light emission path in the organic light emitting display device having a top emission type in FIG. 9.

FIG. 12 is a diagram showing a light emission path in the organic light emitting display device having a bottom emission type in FIG. 9.

FIGS. 13 to 17 are a diagram showing various examples of a shape of a stripe pattern of the first embodiment, respectively.

FIG. 18 is a diagram showing a stacked structure for each organic light emitting device according to the first embodiment.

FIG. 19 is a diagram schematically showing an in-line deposition apparatus for forming the organic light emitting device of the stacked structure of FIG. 18.

FIG. 20 is a diagram showing a stacked structure for each organic light emitting device according to a second embodiment.

FIG. 21 is a diagram showing a stacked structure for each organic light emitting device according to a third embodiment.

FIG. 22 is a diagram schematically showing an organic light emitting display device according to a second embodiment.

FIG. 23 is a view showing an example of a method of forming a protection pattern of FIG. 22.

FIG. 24 is a diagram schematically showing an organic light emitting display device according to a third embodiment.

FIG. 25 is a diagram schematically showing a pixel structure of a general display device.

FIG. 26 is a diagram schematically showing a pixel structure of a display device according to an embodiment.

FIG. 27 is a diagram schematically showing a design model of a pixel of the display device of the embodiment of FIG. 26.

FIG. 28 is a diagram showing a stacked structure for each organic light emitting device according to a fourth embodiment.

FIG. 29 is a diagram showing light compensation by interference using thickness adjustment for each organic light emitting device.

FIG. 30 is a diagram showing a stacked structure for each organic light emitting device according to a fifth embodiment.

FIG. 31 is a diagram showing a stacked structure for each organic light emitting device according to a sixth embodiment.

FIG. 32 is a diagram showing a stacked structure for each organic light emitting device according to a seventh embodiment.

FIG. 33 is a diagram showing a stacked structure for each organic light emitting device according to an eighth embodiment.

FIG. 34 is a diagram showing a stacked structure for each organic light emitting device according to a nineth embodiment.

FIG. 35 is a diagram showing a stacked structure for each organic light emitting device according to a tenth embodiment.

FIG. 36 is a diagram showing a stacked structure for each organic light emitting device according to an eleventh embodiment.

FIG. 37 is a diagram showing a stacked structure for each organic light emitting device according to a twelfth embodiment.

## DETAILED DESCRIPTION OF THE PREFERRED EMBODIMENTS

Hereinafter, embodiments will be described in detail with reference to the drawings. In the following description, unless otherwise specified, the display device can refer to an organic light emitting display device. The row direction or row line can represent an X-axis direction as a first direction, and the column direction or column line can represent a Y-axis direction as a second direction perpendicular to the first direction. In the following description, the row direction, the row line, the first direction, the X-axis direction, etc. can be used interchangeably. In addition, the column direction, the column line, the second direction, the Y-axis direction, etc. can be mixed.

Meanwhile, the first direction can refer to the Y-axis direction, and the second direction can refer to the X-axis direction. In the following description, the plurality of subpixels SPr, SPg and SPb can be in contact with or spaced apart from each other. A pixel P constituting the plurality of subpixels SPr, SPg and SPb can be in contact with or spaced apart from other adjacent pixels P. When the plurality of subpixels SPr, SPg and SPb are spaced apart or adjacent pixels P are spaced apart, a black matrix, a bank, a barrier pattern, a color blocking pattern, etc. can be disposed on the separation area formed by the separation.

Components missing in the following description can be known technologies, but it is obvious that the missing components are also within the scope of the technical idea of the embodiment. In addition, components shown in drawings accompanying various embodiments can differ from corresponding components in actual mass-produced products in structure, shape, thickness, width, area, size, volume, etc., for convenience of description.

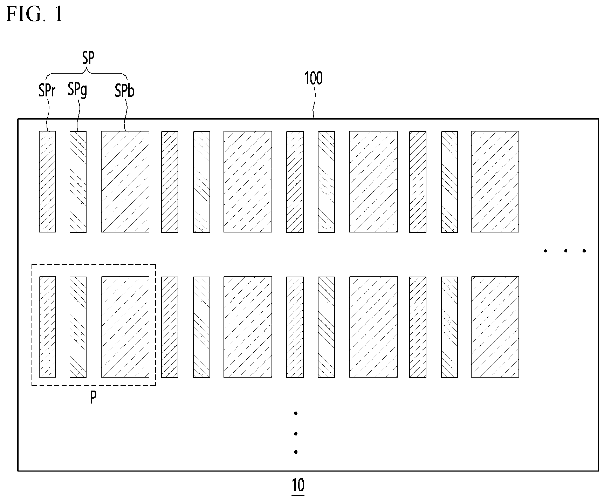

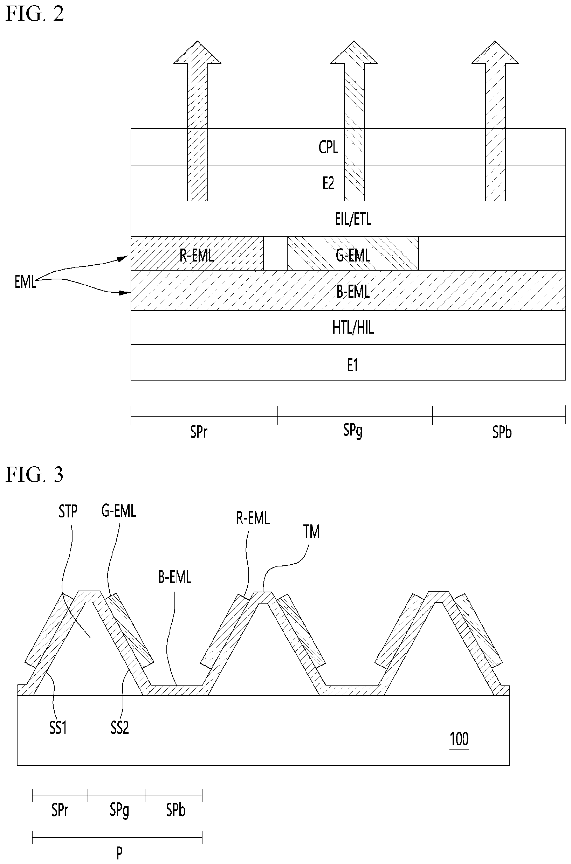

FIG. 1 is a diagram schematically showing an organic light emitting display device according to a first embodiment. FIG. 2 is a diagram schematically showing a stacked structure for each organic light emitting device according to the first embodiment.

Referring to FIG. 1, an organic light emitting display device 10 according to an embodiment can comprise a substrate 100 in which a plurality of pixels P are arranged in a matrix form along a column direction (or a first direction) and a row direction (or a second direction) in a display area. Here, the row direction can be the X-axis direction, and the column direction can be the Y-axis direction.

The organic light emitting display device 10 according to the exemplary embodiment can be a top emission type display device displaying an image by emitting light toward an upper direction of the substrate 100. The organic light emitting display device 10 according to the exemplary embodiment can be a bottom emission type display device displaying an image by emitting light in a downward direction of the substrate 100.

The plurality of pixels P can comprise subpixels of at least three different colors, and can be arranged in the order of for example, a red subpixel SPr, a green subpixel SPg and a blue subpixel, but is not limited thereto. For example, the red subpixel SPr can be referred to as a first subpixel, the green subpixel SPg can be referred to as a second subpixel, and the blue subpixel SPb can be referred to as a third subpixel. Although not shown, the green subpixel SPg, the red subpixel SPr, and the blue subpixel SPb can be arranged in the order along the first direction (X-axis direction). Although not shown, the red subpixel SPr, the blue subpixel SPb, and the green subpixel SPg can be arranged in the order along the first direction (X-axis direction).

Meanwhile, in the embodiment, each of the subpixels SPr, SPg and SPb can be arranged in a stripe manner. The subpixels SPr, SPg and SPb of the same color can be disposed on the same column line, and the subpixels SPr, SPg and SPb of different colors can be alternately and repeatedly disposed in unit of the column line. That is, the subpixels SPr, SPg and SPb of the same color can be arranged in a stripe shape elongated along the second direction (Y-axis direction). For example, the red subpixels SPr can be arranged in a stripe shape elongated along the second direction. For example, the green subpixel SPg can be adjacent to the red subpixel SPr in a first direction and can be arranged in a stripe shape elongated along the second direction. For example, the blue subpixel SPb can be adjacent to the green subpixel SPg in the first direction and can be arranged in a stripe shape elongated along the second direction.

In this case, the red subpixel SPr, the green subpixel SPg, and the blue subpixel SPb disposed adjacent to each other in the row line direction can constitute a pixel P, which is a unit of color display.

As such, in the embodiment, the subpixels SPr, SPg and SPb of different colors can be arranged in a side-by-side structure along the row line direction.

Each of the subpixel SPr, SPg and SPb can be provided with an organic light emitting device emitting a corresponding color.

As shown in FIG. 2, a red organic light emitting device can be disposed in the red subpixel SPr, a green organic light emitting device can be disposed in the green subpixel SPg, and a blue organic light emitting device can be disposed in the blue subpixel SPb. For example, the red organic light emitting device can be referred to as a first organic light emitting device, the green organic light emitting device can be referred to as a second organic light emitting device, and the blue organic light emitting device can be referred to as a third organic light emitting device, but is not limited thereto.

The red organic light emitting device, the green organic light emitting device, and the blue organic light emitting device can comprise a first electrode E1 as a lower electrode, a second electrode E2 as an upper electrode, and an organic light emitting layer R-EML, G-EML and B-EML interposed between the first electrode E1 and the second electrode E2, respectively. That is, the red organic light emitting device can comprise a red organic light emitting layer R-EML generating red light, the green organic light emitting device can comprise a green organic light emitting layer G-EML generating green light, and the blue organic light emitting device can comprise a blue organic light emitting layer B-EML generating blue light. For example, the red organic light emitting layer R-EML can be referred to as a first organic light emitting layer, the green organic light emitting layer G-EML can be referred to as a second organic light emitting layer, and the blue organic light emitting layer B-EML can be referred to as a third organic light emitting layer.

Here, the first electrode E1 can be one of an anode electrode and a cathode electrode, and the second electrode E2 can be the other one of an anode electrode and a cathode electrode. In the embodiment, a case where the first electrode E1 is an anode electrode and the second electrode E2 is a cathode electrode can be taken as an example.

In addition, the red organic light emitting device, the green organic light emitting device, and the blue organic light emitting device can comprise a hole transport structure between the first electrode E1 and the organic light emitting layers R-EML, G-EML, and B-EML and an electron transport structure between the organic light emitting layers R-EML, G-EML and B-EML and the second electrode E2, respectively. Each of the hole transport structure and the electron transport structure can comprise a plurality of organic layers. Alternatively, each of the hole transport structure and the electron transport structure can comprise a plurality of organic layers and at least one inorganic layer. For example, the hole transport structure can be termed a first transport structure, the electron transport structure can be termed a second transport structure, or vice versa.

The hole transport structure can comprise a hole injection layer HIL and/or a hole transport layer HTL, but can also comprise more organic layers. The hole injection layer HIL and/or hole transport layer HTL can serve to supply holes to the organic light emitting layers R-EML, G-EML and B-EML. The electron transport structure can function to inject electrons, and the electron transport layer ETL can comprise an electron injection layer EIL and/or an electron transport layer ETL, but can also comprise more organic layers. The electron injection layer EIL and/or the electron transport layer ETL can serve to supply electrons to the organic light emitting layers R-EML, G-EML and B-EML. The stacked structure of the organic light emitting layer shown in FIG. 2 can be an example, and various modifications are possible, and various deformable stacked structures will be described later.

A plurality of organic materials included in the hole transport structure and/or the electron transport structure can be commonly disposed in each of the red subpixel SPr, the green subpixel SPg, and the blue subpixel Spb. Accordingly, the hole transport structure and/or the electron transport structure can be named a common layer. That is, the hole transport structure can be referred to as a first common layer, and the electron transport structure can be referred to as a second common layer or vice versa. According to an embodiment, even if a common layer is commonly disposed in each of the red subpixel SPr, the green subpixel SPg, and the blue subpixel Spb, the thickness of the common layer of each of the red subpixel SPr, the green subpixel SPg, and the blue subpixel SPg can be different from each other. This can be implemented by a stripe pattern STP having at least two areas in which the red subpixel SPr and the green subpixel SPg are defined and a plurality of evaporation sources for evaporating a red light emitting material, a green light emitting material, and a blue light emitting material in different directions with respect to the substrate 100. Although not shown, a plurality of organic materials included in the hole transport structure and/or the electron transport structure can be disposed separately from each other in each of the subpixel SPr, green subpixel SPg, and blue subpixel Spb.

Meanwhile, in an embodiment, the blue organic light emitting layer B-EML can be disposed in the blue subpixel SPb as well as the red subpixel SPr and the green subpixel SPr. That is, the blue organic light emitting layer B-EML can be commonly disposed in the red subpixel SPr, the green subpixel SPr, and the blue subpixel SPb. In this case, the red organic light emitting layer R-EML and the green organic light emitting layer G-EML can be disposed on the blue organic light emitting layer B-EML. In this case, holes of the hole transport structure can be supplied to the red organic light emitting layer R-EML or the green organic light emitting layer G-EML via the blue organic light emitting layer B-EML. In addition, electrons of the electron transport structure can be supplied to the red organic light emitting layer R-EML or the green organic light emitting layer G-EML. Accordingly, light can be generated while returning to the ground state after the light emitting material is excited by energy due to the combination of holes and electrons in the red organic light emitting layer R-EML or the green organic light emitting layer G-EML.

Meanwhile, a capping layer CPL can be positioned on the second electrode E2.

Meanwhile, in the embodiment, at least two inclined surfaces SS1 and SS2 of the stripe pattern STP and a separation interval between the adjacent stripe patterns STP can be provided. In addition, evaporation sources can be disposed to evaporate the corresponding light emitting material to face the corresponding inclined surfaces SS1 and SS2 and the separation interval. Accordingly, the corresponding light emitting material evaporated by the corresponding evaporation sources can be directly deposited on each of the at least two inclined surfaces SS1 and SS2 and the separation interval. Accordingly, a red organic light emitting device can be formed as a red subpixel SPr on the first inclined surface SS1, and a green organic light emitting device can be formed as a green subpixel SPg on the second inclined surface SS2, and a blue organic light emitting device can be formed as a blue subpixel SPb on the separation interval. As a result, by not using FMM or drastically reducing the number of FMMs, the cost can be significantly reduced and the manufacturing process can be drastically simplified.

This will be described in detail with reference to FIG. 3. FIG. 3 is a cross-sectional view schematically showing a stripe pattern and a light emitting layer according to a first embodiment. In FIG. 3, for convenience of description, the stripe pattern and the light emitting layer are mainly shown, and other components are omitted.

Referring to FIGS. 1 to 3, a plurality of stripe patterns STP extending in a column line direction can be formed on the substrate 100 of the organic light emitting display device 10.

In this case, the stripe pattern STP can be repeatedly disposed for each pixel P along the row line direction. That is, the stripe pattern STP can be periodically disposed in units of pixels P.

The stripe pattern STP can be formed to correspond to a column line area in which two adjacent subpixels SP, for example, a red subpixel SPr and a green subpixel SPg can be formed. That is, the red subpixel SPr and the green subpixel SPg can be positioned in the corresponding first and second areas of the stripe pattern STP, respectively. Each of the subpixel SPr and the green subpixel SPg can be elongated along the length direction of the stripe pattern STP. The blue subpixel SPb can be positioned in a separation area between two the adjacent stripe patterns STP, that is, in a third area. The blue subpixel SPb can be elongated along the length direction of the stripe pattern STP.

The stripe pattern STP can be formed in a tapered shape in which the width is narrowed in an upper direction of the substrate 100 (i.e., in a direction away from the substrate 100), and both side surfaces in the width direction can be formed as inclined surfaces. In the embodiment, for convenience of description, the inclined side surface located on the left side of the drawing can be referred to as a first inclined surface SS1 and the inclined side surface located on the right side can be referred to as a second inclined surface SS2. For example, the first inclined surface SS1 can be referred to as a first area, and the second inclined surface SS2 can be referred to as a second area, but this is not limited thereto.

As will be described later, the stripe pattern STP can be formed to have a constant width along the upper direction of the substrate 100. That is, the stripe pattern STP can have the first inclined surface SS1 and the second inclined surface SS2 perpendicular to the plane (or the ground), respectively.

Meanwhile, the stripe pattern STP can be configured to have an upper surface (or top surface) TM connecting upper ends of the first and second inclined surfaces SS1 and SS2 between the first and second inclined surfaces SS1 and SS2. The upper surface TM can have a substantially flat planar shape, but is not limited thereto and can have a curved shape.

A red subpixel SPr and a green subpixel SPg of the pixel P can be positioned to correspond to the first and second inclined surface surfaces SS1 and SS2, respectively. The blue subpixel SPb can be positioned to correspond to the separation area between the adjacent stripe patterns STP.

Meanwhile, in the organic light emitting display device 10 according to the embodiment, the blue light emitting layer B-EML can be formed not only in the corresponding blue subpixel SPb but also in the red subpixel SPr and the green subpixel SPg. In other words, the blue light emitting layer B-EML can be formed in common the entire area of the substrate 100, that is, all subpixels SP, that is, the red subpixel SPr, the green subpixel SPg, and the blue subpixel SPb. This structure can be called the blue common structure.

In this blue common structure, the blue light emitting layer B-EML can cover the stripe pattern STP and also cover the separation area of the substrate 100 between the adjacent stripe patterns STP.

In such a blue common structure, the blue light emitting layer B-EML located in the blue subpixel SPb can function to generate blue color. The blue light emitting layer B-EML located in the red subpixel SPr and the green subpixel SPg, that is, the first slop SS1 and the second inclined surface SS2 can function as a charge transport layer (e.g., a hole transport layer).

As such, in the embodiment, there is no need to use a separate deposition pattern mask such as FMM when depositing the blue light emitting layer B-EML.

The red light emitting layer R-EML can be deposited on the corresponding first inclined surface SS1, and the green light emitting layer G-EML can be deposited on the corresponding second inclined surface SS2. More specifically, the red light emitting layer R-EML can be deposited on a portion of the blue light emitting layer B-EML located on the corresponding first inclined surface SS1, and the green light emitting layer G-EML can be deposited on a portion of the blue light emitting layer B-EML located on the corresponding second inclined surface SS2.

In contrast, in the embodiment, the stripe pattern STP with an inclined shape can be provided, and the red light emitting material can be selectively deposited on the corresponding first inclined surface SS1 due to a shadow effect of the stripe pattern STP. The red light emitting layer R-EML can be formed in a pattern, and the green light emitting material can be selectively deposited on the corresponding second inclined surface SS2 to form the green light emitting layer G-EML in a pattern.

As such, by using the stripe pattern STP, the red light emitting layer R-EML and the green light emitting layer G-EML can be formed in a pattern form in a desired area by a self-aligned (or self-matched) deposition method.

Accordingly, there is no need to use a separate deposition pattern mask such as FMM when depositing the red light emitting layer R-EML and the green light emitting layer G-EML.

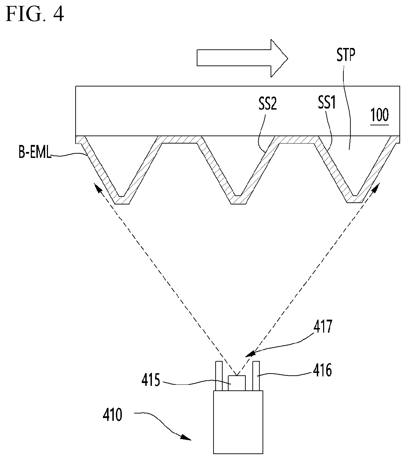

Hereinafter, with further reference to FIGS. 4 to 6, a method of depositing a red light emitting layer, a green light emitting layer, and a blue light emitting layer according to the first embodiment will be described.

In FIGS. 4 to 6, for convenience of explanation, a case in which the light emitting material is deposited while the substrate 100 on which the stripe pattern STP is formed moves in the right direction on the drawing can be taken as an example.

The substrate 100 can be disposed so that the stripe pattern STP faces downward. Accordingly, evaporation sources 410 to 430 located at a predetermined interval and evaporating the light emitting material deposited on the substrate 100 can be located below the substrate 100.

Referring to FIG. 4 in relation to the deposition of the blue light emitting layer B-EML, in the deposition chamber of the blue light emitting layer B-EML, the substrate 100 on which the stripe pattern STP is formed can move in a row direction (or X-axis direction) perpendicular to the column direction (or Y-axis direction) in which the stripe pattern STP extends and can be deposited on the substrate 100 while the substrate 100 moves.

In contrast, a first nozzle 415 for discharging the evaporated light emitting material can be located on the upper surface of the first evaporation source 410 of the blue light emitting material, and the first nozzle 415 can extend in a normal direction (or Z-axis direction) to the plane of the substrate 100, that is, a direction perpendicular to the plane of the substrate 100.

Meanwhile, a first angle limiting plate 416 can be provided to limit the deposition angle and/or the deposition range. A first angle limiting plate 416 defining an opening 417 having a wider width than the first nozzle 415 (or the first evaporation source 410) can be provided on the first nozzle 415. In this regard, for example, the first angle limiting plate 416 extending in a direction perpendicular to both sides of the first nozzle 415 can be disposed, and an upper end of the first angle limiting plate 416 can be located higher than the first nozzle 415. In order to increase the efficiency of material use of the light emitting material, a deposition apparatus can be configured such that the distance between the substrate 100 and the first nozzle 415 can be reduced, and the distance (i.e., offset value) of the first angle limiting plate 416 from the first nozzle 415 can be increased.

The distance between the substrate 100 and the first nozzle 415 can be fixed, and according to the offset value of the first angle limiting plate 416 on the top of the first evaporation source 410, the blue light emitting material can be discharged while adjusting the size of the hemisphere direction, the blue light emitting material can be continuously deposited on the entire surface of the substrate 100 according to an appropriate offset value. Here, the red and green subpixels SPr and SPg can be positioned corresponding to the inclined surfaces of the stripe pattern STP, and the blue subpixel SPb can be positioned corresponding to the plane of the substrate 100. Accordingly, in subpixels of different colors, the blue light emitting layer B-EML can have different thicknesses.

Meanwhile, the blue light emitting layer B-EML can be formed to have the same thickness for subpixels of the same color. For example, the blue light emitting layer B-EML having the same thickness can be formed in the red subpixels SPr. The blue light emitting layer B-EML having the same thickness can be formed in the green subpixels SPg, and the blue light emitting layer B-EML having the same thickness can be formed in the blue subpixels SPb.

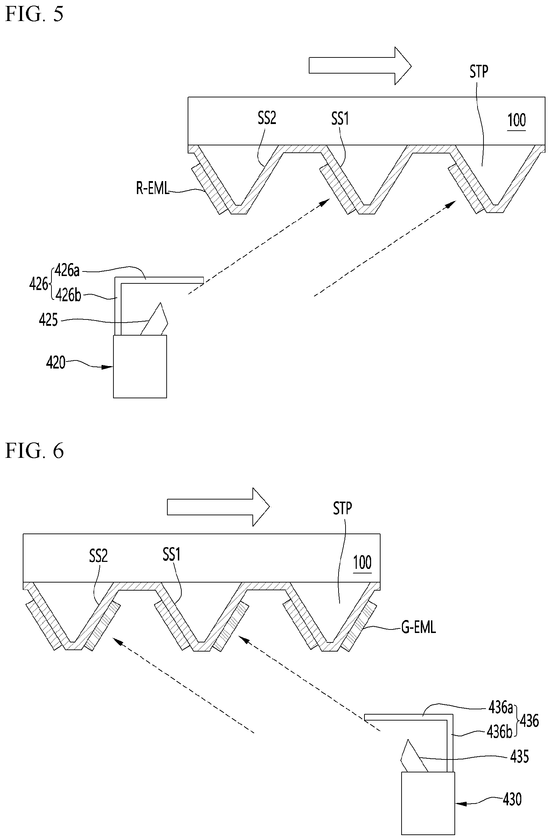

Referring to FIG. 5 in relation to the deposition of the red light emitting layer R-EML, in the deposition chamber of the red light emitting layer R-EML, the substrate 100 on which the blue light emitting layer B-EML is formed moves in a row direction, and a red light emitting material can be deposited on the substrate 100 while the substrate 100 is moving.

In contrast, a second nozzle 425 for discharging the evaporated light emitting material can be located on the upper surface of the second evaporation source 420 of the red light emitting material, and the second nozzle 425 can extend in an inclined direction with respect to a direction perpendicular to the plane of the substrate 100. That is, the second nozzle 425 can be inclined so as to face the first inclined surface SS1 of the stripe pattern STP corresponding to the deposition surface of the red light emitting material. At this time, by setting the second angle limiting plate 426 to a deposition angle optimized for the structure of the pre-evaporation substrate, the red light emitting layer R-EML may not be deposited in a separation area between the adjacent stripe patterns STP (or blue subpixel SPb). Here, the second angle limiting plate 426 can be disposed on the second evaporation source 420 to cover it. For example, the second angle limiting plate 426 can comprise a horizontal portion 426a 2 covering an evaporation source 420 on the evaporation source 420 and a vertical portion 426b located in a direction (i.e., the left direction in the drawing) opposite to the inclination direction of the second nozzle 425 (i.e., the right direction in the drawing) and bent downward from the horizontal portion 426a to extend.

As such, the second nozzle 425 can be configured to be inclined forward to look at the first inclined surface SS1, which is a backward inclined surface based on the substrate moving direction.

In this case, when the substrate 100 is viewed from the second nozzle 425, a separation area between the second inclined surface SS2 and the stripe pattern STP can correspond to a shadow area, and the first inclined surface SS1 can correspond to a visible area.

Accordingly, the red light emitting material can be discharged from the second nozzle 425 and be substantially perpendicularly incident on the first inclined surface SS1.

Accordingly, the red light emitting material can be substantially deposited on the first inclined surface SS1 to form the red light emitting layer R-EML in the red subpixel SPr.

Referring to FIG. 6 in relation to the deposition of the green light emitting layer G-EML, in the deposition chamber of the green light emitting layer G-EML, the substrate 100 on which the red light emitting layer R-EML is formed moves in a row direction, a green light emitting material can be deposited on the substrate 100 while the substrate 100 is moving.

In contrast, a third nozzle 435 for discharging the evaporated light emitting material can be located on the upper surface of the third evaporation source 430 of the green light emitting material, and the third nozzle 435 can extend in a direction inclined with respect to a direction perpendicular to the plane of the substrate 100. That is, the third nozzle 435 can be inclined to face the second inclined surface SS2 of the stripe pattern STP corresponding to the deposition surface of the green light emitting material.

Here, the third angle limiting plate 436 can be disposed on the third evaporation source 430 to cover it. For example, the third angle limiting plate 436 can comprise a horizontal portion 436a covering a third evaporation source 430 on the third evaporation source 430 and a vertical portion 436b located in a direction (i.e., the right direction in the drawing) opposite to the inclination direction of the nozzle 435 (i.e., the left direction in the drawing) and bent downward from the horizontal portion 436a to extend.

As such, the third nozzle 435 can be configured to be inclined backward in order to view the second inclined surface SS2 which is a forward inclined surface based on the substrate moving direction. That is, the third nozzle 435 can be inclined in the opposite direction to the second nozzle 425.

In this case, when the substrate 100 is viewed from the third nozzle 435, the separation area between the first inclined surface SS1 and the stripe pattern STP can correspond to the shadow area, and the second inclined surface SS2 can correspond to a visible area.

Accordingly, the green light emitting material can be discharged from the third nozzle 435 and be substantially vertically incident on the second inclined surface SS2.

Accordingly, the green light emitting material can be substantially deposited on the second inclined surface SS2 to form the green light emitting layer G-EML in the green subpixel SPg.

Meanwhile, in the foregoing, the case of forming the green light emitting layer G-EML after the formation of the red light emitting layer R-EML can have been exemplified, but the deposition process can be performed in the opposite way.

Meanwhile, in relation to the formation of the blue light emitting layer B-EML, the thickness of the blue light emitting layer B-EML formed on the red and green subpixels SPr and SPg can be formed thinner than the thickness of the blue light emitting layer B-EML formed on the blue subpixel SPb. Furthermore, by minimizing the influence of the thickness of the blue light emitting layer B-EML due to the deposition shadow caused by the first and second inclined surfaces SS1 and SS2 of the red and green subpixels SPr and SPg, the blue light emitting layer B-EML of the blue subpixel SPb can have a constant thickness within the substrate.

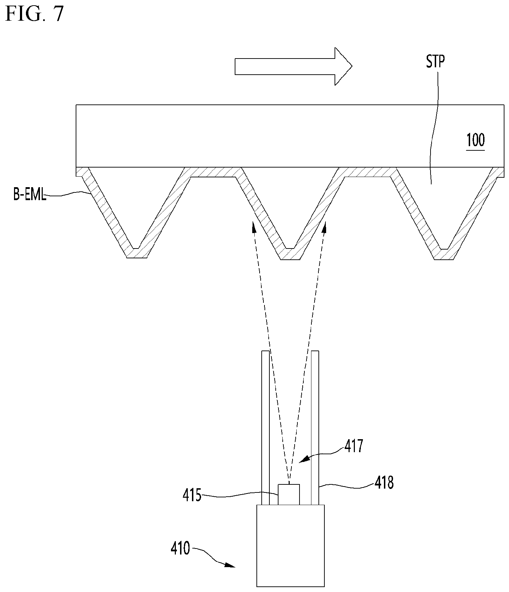

In this regard, reference can be made to FIG. 7. A fourth angle limiting plate 418 defining an opening 417 having a predetermined width can be disposed between the first evaporation source 410 of the blue light emitting material and the substrate 100. For example, the opening 417 can have a wider width than the first evaporation source 410 (or the first nozzle 415).

Here, the upper end of the fourth angle limiting plate 418 can be higher than that of the first angle limiting plate 416 discussed above so that the deposition angle becomes narrower compared to the case of using the first angle limiting plate 416.

When the fourth angle limiting plate 418 is used, the incident angle of the blue light emitting material to the substrate 100 can be narrowed close to a vertical line.

Accordingly, the thickness of the blue light emitting layer B-EML deposited on the first and second inclined surfaces SS1 and SS2 of the red and green subpixels SPr and SPg can become thinner. For example, the thickness of the blue light emitting layer B-EML of the red and green subpixels SPr and SPg can be approximately 80% or less of the thickness of the blue light emitting layer B-EML of the blue subpixel SPb.

As such, when the thickness of the blue light emitting layer B-EML becomes thinner, the effect of the blue dopant on the organic light emitting device of the red and green subpixels SPr and SPg can be minimized, thereby improving color tone and device efficiency.

The first evaporation source 410 can also be applied to all common layers (e.g., a hole injection layer HIL, a hole transport layer HTL, an electron injection layer EIL, an electron transport layer ETL, and a capping layer CPL) in addition to the blue light emitting layer B-EML. At this time, the thickness of the common layer deposited for each subpixel SP can be optimized by designing an appropriate offset value of the angle limiting plate for the common layer. Therefore, depending on the product, if it is necessary to differentiate the common layer for each subpixel, such as improving optical characteristics, the structure of various combinations of evaporation sources and angle limiting plates can be possible.

On the other hand, in order to improve or adjust the uniformity of the thickness of the common layer, a method of optimizing the structure of the evaporation source as shown in FIGS. 4 and 7 can be used, or a method of changing the movement of the substrate in the deposition apparatus can be used.

In this regard, for example, when depositing the common layer including the blue light emitting layer B-EML, the movement direction of the substrate 100 can be the column direction (second direction) in which the stripe pattern STP extends. When depositing the red light emitting layer R-EML and the green light emitting layer G-EML, the moving direction of the substrate 100 can be a row direction perpendicular to the column direction. In this case, the influence of the shadow effect by the stripe pattern STP on the deposition uniformity of the common layer can be minimized, and the degree of freedom in the design of the angle limiting plate of the evaporation source can be increased, thereby improving the efficiency of material use. In this case, a chamber for rotating the substrate can be added to the deposition apparatus.

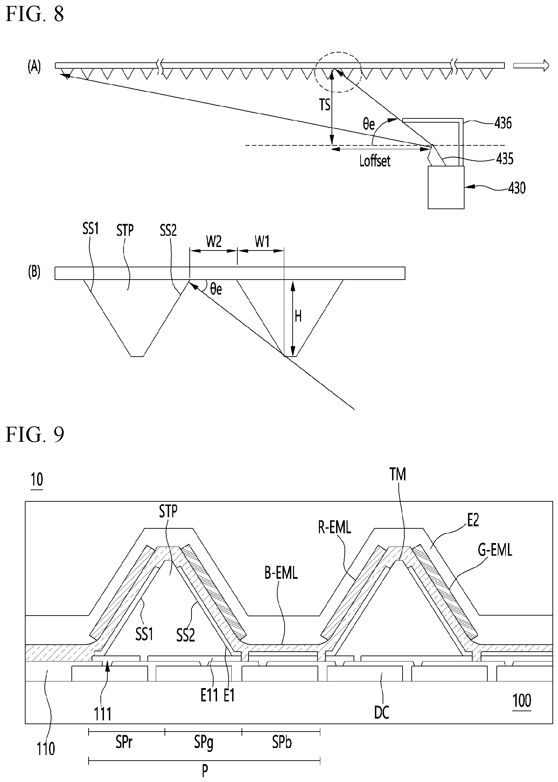

Further referring to FIG. 8, the design structure of the stripe pattern STP and the design structure of the deposition apparatus will be described in more detail. In FIG. 8, for convenience of description, the deposition of the green light emitting layer G-EML can be taken as an example, and the blue light emitting layer B-EML and the first electrode E1 formed under the green light emitting layer G-EML are not shown. FIG. 8(B) is an enlarged view of a part of the substrate of FIG. 8(A).

In the deposition of the light emitting material on the inclined surface, the main factors for designing the stripe pattern STP can be a height H, a first width W1, and a second width W2. The height H can be the height of the stripe pattern STP. The first width W1 can be a width projected perpendicular to the first inclined surface SS1 of the stripe pattern STP. The second width W2 can be the width of a separation area between the adjacent stripe patterns STP.

The deposition angle $\theta e$ (or the maximum deposition angle) for depositing the corresponding green light emitting material on the second inclined surface SS2 by the shadow effect can be expressed by Equation 1 below.

$$\text{Equation 1: } \tan\theta e = H/(W1 + W2)$$

In this regard, with respect to the plane of the substrate 100 as a reference, a virtual line connecting one end of the upper surface TM of the stripe pattern STP located in front of the lower point from the lower point of the effective light emitting area of the green subpixel SPg can be drawn, and this virtual line will actually correspond to the deposition angle $\theta e$ of Equation 1.

Meanwhile, the components of the deposition apparatus for depositing the inclined surface as above can be arranged to satisfy the deposition angle $\theta e$.

In contrast, a third angle limiting plate 436 can be disposed between the third evaporation source 430 of the green light emitting material and the substrate 100 in the green light emitting layer deposition chamber.

The third angle limiting plate 436 can be substantially wider than the third evaporation source 430 so as to cover all of the third evaporation source 430.

On the other hand, the third nozzle 435 of the third evaporation source 430 can be inclined backward to look at the second inclined surface SS2.

At this time, a third evaporation source 430 and a third angle limiting plate 436 can be disposed so that a virtual line connecting the third nozzle 435 and the rear end (i.e., one end in the deposition direction) of the third angle limiting plate 436 becomes the deposition angle $\theta e$, which can be expressed by Equation 2 below.

$$\text{Equation 2: } \tan\theta e = TS/Loffset$$

Here, TS can be the vertical distance between the substrate 100 and the third evaporation source 430 (more specifically, the third nozzle 435), and Loffset can be the shortest horizontal distance from the third evaporation source 430 to a point on the substrate 100 where the light emitting material can be deposited.

It is desirable to design the stripe pattern STP and the deposition apparatus so that Equations 1 and 2 above can be satisfied.

Further referring to FIG. 9, the structure of the organic light emitting display device according to the embodiment will be described in more detail.

Referring to FIG. 9, in the organic light emitting display device 10 according to the embodiment, a driving circuit DC for driving each subpixel SP can be formed on the substrate 100. The driving circuit DC can comprise a plurality of transistors including a driving transistor and at least one capacitor.

A planarization layer 110 made of an insulating material can be formed on the driving circuit DC. A contact hole 111 exposing one electrode of the driving circuit DC can be formed in the planarization layer 110. Here, one electrode of the driving circuit DC can be a drain electrode of any one transistor included in the driving circuit DC.

An auxiliary electrode (or connection electrode) E11 patterned in units of each subpixel SP can be formed on the planarization layer 110. The auxiliary electrode E11 can be regarded as corresponding to one electrode layer constituting the first electrode E1, and the auxiliary electrode E11 can contact one electrode of the driving circuit DC through the contact hole 111 of the corresponding subpixel SP. The auxiliary electrode E11 and the first electrode E1 can comprise different metals, but are not limited thereto. The auxiliary electrode E11 and/or the first electrode E1 can be a single layer or can comprise a plurality of metal layers.

In contrast, the first auxiliary electrode E11 can be referred to as a first anode electrode, the first electrode E1 can be referred to as a second anode electrode, and the first electrode can be configured by the first anode electrode and the second anode electrode.

A stripe pattern STP can be formed on the auxiliary electrode E11 of the red subpixel SPr and the green subpixel SPg.

The stripe pattern STP can be positioned to correspond to an area where the red subpixel SPr and the green subpixel SPg are formed.

At this time, one end of the auxiliary electrode E11 of the red subpixel SPr can be positioned outside the first inclined surface SS1 of the stripe pattern STP and can be exposed without being covered by the stripe pattern STP.

The other end of the auxiliary electrode E11 of the green subpixel SPg can be positioned outside the second inclined surface SS2 of the stripe pattern STP and can be exposed without being covered by the stripe pattern STP.

Meanwhile, the auxiliary electrode E11 of the blue subpixel SPb can be positioned between the adjacent stripe patterns STP and can be exposed without being covered by the stripe pattern STP.

The stripe pattern STP can be made of an organic insulating material and can be formed by a printing method or a photolithography method. As the organic insulating material, polyimide or acrylic resin can be used, but is not limited thereto.

After forming the stripe pattern STP, the first electrode E1 patterned in units of each subpixel SP can be formed. The first electrode E1 can be connected to the driving circuit DC by contacting the auxiliary electrode E11 positioned below the first electrode E1.

In this regard, the first electrode E1 of the red subpixel SPr can be formed along the first inclined surface SS1 of the stripe pattern STP, and a lower end thereof can contact one end of the auxiliary electrode E11.

The first electrode E1 of the green subpixel SPg can be formed along the second inclined surface SS2 of the stripe pattern STP, and a lower end thereof can contact the other end of the auxiliary electrode E11.

Meanwhile, the first electrode E1 of the blue subpixel SPb can be positioned between the adjacent stripe patterns STP and can entirely contact the auxiliary electrode E11 below the first electrode E1.

After forming the first electrode E1, a common layer can be formed on the substrate 100 in the order of a hole injection layer HIL and a hole transport layer HTL, and another common layer, and a blue light emitting layer B-EML, which is another common layer, can be deposited and formed on the hole transport layer HTL.

The blue light emitting layer B-EML can be commonly formed in all subpixels SPr, SPg and SPb, and can be formed on the first and second inclined surfaces SS1 and SS2 of the stripe pattern STP and the separation area between the adjacent patterns STP.

After forming the blue light emitting layer B-EML, the red light emitting layer R-EML can be deposited and formed on the blue light emitting layer B-EML located on the corresponding first inclined surface SS1, and the green light emitting layer G -EML can be deposited and formed on the blue light emitting layer B-EML located on the corresponding second inclined surface SS2.

After forming the red light emitting layer R-EML and the green light emitting layer G-EML, the electron transport layer ETL and the electron injection layer EIL can be formed as a common layer on the substrate 100, and the second electrode E2 can be formed on the substrate 100. The second electrode E2 can be commonly formed on an entire area of the substrate 100.

As described above, the red organic light emitting device can be disposed on the first inclined surface SS1 of the stripe pattern STP, the green organic light emitting device can be disposed on the second inclined surface SS2 of the stripe pattern STP, and the blue organic light emitting device can be disposed on a separation area between the adjacent stripe patterns STP. The first inclined surface SS1 and the second inclined surface SS2 can have an inclined surface inclined with respect to the separation area, respectively. At this time, the first inclination angle of the first inclined surface SS1 and the second inclination angle of the second inclined surface SS2 can be the same or different.

Accordingly, directions of light emitted from each of the red organic light emitting device, the green organic light emitting device, and the blue organic light emitting device can be different. For example, red light can be emitted in the 10 o'clock direction through the upper surface of the red organic light emitting device. For example, green light can be emitted in a direction of 2 o'clock through an upper surface of the green organic light emitting device. For example, blue light can be emitted in the 12 o'clock direction through the upper surface of the blue organic light emitting device.

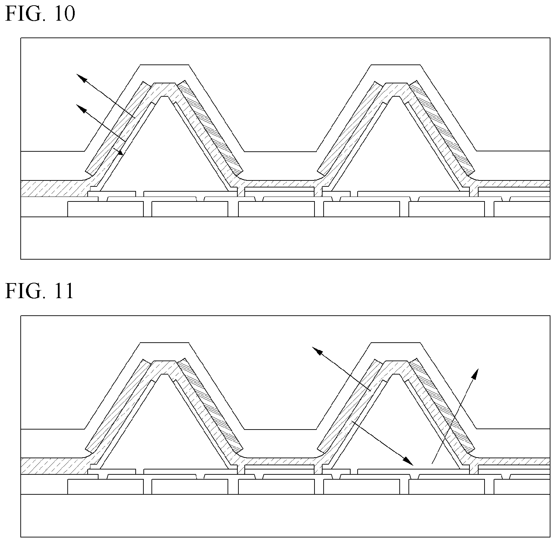

Meanwhile, in the case where the organic light emitting display device 10 configured as described above is a top emission type, the lower electrode including the auxiliary electrode E11 and the first electrode E1 can have a reflective characteristic and the second electrode E2 as an upper electrode can have transmissive or transflective characteristics. In this regard, for example, the auxiliary electrode E11 can be made of ITO, Ti or Mo, and the first electrode E1 can be made of ITO/(Ag or Ag alloy)/ITO to have a high reflectance. Meanwhile, the second electrode E2 can be made of ITO or Mg-Ag. FIG. 10 can be referred to in relation to the light path in this case, and FIG. 10 shows the light output path of the red subpixel SPr as an example.

As another example, the auxiliary electrode E11 can have a single-layer structure of Ag, Ag alloy, a single layer including Al, or a multi-layer structure including Ag or Ag alloy (e.g., ITO/(Ag or Ag alloy)/ITO, ITO/(Ag or Ag alloy)/Ti or ITO/(Ag or Ag alloy)/Mo). Also, the first electrode E1 can be formed of an ITO single layer and the second electrode E2 can be formed of ITO or Mg-Ag. FIG. 11 can be referred to in relation to the light path in this case, and FIG. 11 shows the light output path of the red subpixel SPr as an example.

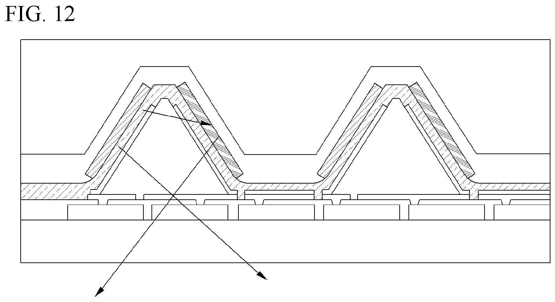

In the case where the organic light emitting display device 10 configured as above is a bottom emission type, both the auxiliary electrode E11 and the first electrode E1 constituting the lower electrode have transmissive characteristics, and the second electrode E2 can have reflective characteristics. In this regard, for example, the second electrode E2 can be made of Al. Regarding the light path in this case, reference can be made to FIG. 12, and FIG. 12 shows the light output path of the red subpixel SPr as an example.

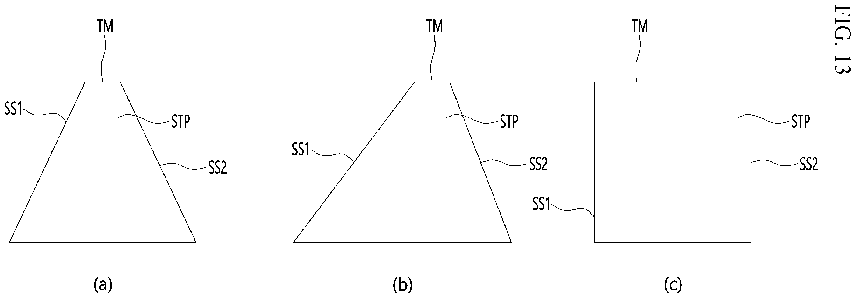

On the other hand, the stripe pattern STP of the embodiment can have various shapes, which can refer to FIGS. 13 to 17.

As shown in FIGS. 13A to 13C, the stripe pattern STP can have at least two or more surfaces.

As an example, the stripe pattern STP can have a symmetric polygonal shape (FIG. 13A). A stripe pattern STP having such a symmetric polygonal shape has already been described above. For example, the stripe pattern STP can have a first inclined surface SS1, a second inclined surface SS2, and an upper surface TM. In this case, the first inclined surface SS1 and the second inclined surface SS2 can be symmetrical to each other with respect to a vertical line. For example, the internal angle of the first inclined surface SS1 with respect to the plane (or the ground) and the internal angle of the second inclined surface SS2 with respect to the plane can be the same. Here, the internal angle can be referred to as an inclination angle. At this time, the internal angle can be an acute angle. The length of the first inclined surface SS1 or the second inclined surface SS2 can be greater than the length of the upper surface TM. The area of the first inclined surface SS1 or the second inclined surface SS2 can be greater than the area of the upper surface TM.

Meanwhile, a red light emitting layer R-EML can be disposed on the first inclined surface SS1 and a green light emitting layer G-EML can be disposed on the second inclined surface SS2. Since the amount of light increases as the area of the red light emitting layer R-EML or the green light emitting layer G-EML increases, the area of the upper surface TM can be minimum or 0, and the area of the first inclined surface SS1 or the second inclined surface SS2 can have a maximum. Here, the area of the upper surface TM can be determined by using a patterning method suitable for the resolution of the product so that each of the height and inclination angle of the stripe pattern STP can be managed identically or similarly in each of the subpixels SPr, SPg and SPb of each of the plurality of pixels P on the substrate 100. For example, in the case of patterning by photolithography, process management can be possible only when the area exceeds a certain level.

As another example, the stripe pattern STP can have an asymmetric polygonal shape (FIG. 13B).

For example, the stripe pattern STP can have a first inclined surface SS1, a second inclined surface SS2, and an upper surface TM. In this case, the first inclined surface SS1 and the second inclined surface SS2 can be asymmetrical with respect to a vertical line. For example, the internal angle of the first inclined surface SS1 with respect to the plane can be different from the internal angle of the second inclined surface SS2 with respect to the plane. Here, the internal angle can be referred to as an inclination angle. At this time, the internal angle can be an acute angle. The length of the first inclined surface SS1 or the second inclined surface SS2 can be greater than the length of the upper surface TM. The length of the first inclined surface SS1 can be greater than that of the second inclined surface SS2. An area of the first inclined surface SS1 can be greater than an area of the second inclined surface SS2. Although not shown, the length of the second inclined surface SS2 can be greater than the length of the first inclined surface SS1. The area of the second inclined surface SS2 can be greater than that of the first inclined surface SS1.

Meanwhile, a red light emitting layer R-EML can be disposed on the first inclined surface SS1 and a green light emitting layer G-EML can be disposed on the second inclined surface SS2.

Since the red light emitting layer R-EML, the green light emitting layer G-EML, and the blue light emitting layer B-EML have different lifespans, it can be desirable to design different areas for each subpixel. Therefore, according to the embodiment, the internal angles (60 degrees to 95 degrees) and the width (W2 in FIG. 8(B)) of each of the first and second inclined surfaces SS1 and SS2 can be optimized as design variables. That is, since the lifespan of a product is determined

EP 4 529 400 A1

by the subpixel having the lowest lifespan, the lifespan of the entire product can be increased by optimizing the area ratio between the R, G, and B subpixels SPr, SPg and SPb. If the product lifespan is sufficiently satisfied, the luminance of the product can be improved. In addition, when a design margin is generated in luminance, power consumption can be reduced. Additionally, a sufficient process margin must be secured in order to increase productivity and yield. The design margin can be optimized in terms of inclination angle, distance between anodes, etc. so that process margins can be sufficiently secured.

However, according to the embodiment, the area of the inclined surface on which the light emitting layer with relatively low luminance is disposed can be increased, and the area of the inclined surface on which the light emitting layer with relatively high luminance is disposed can be reduced. For example, when the luminance of the red light emitting layer R-EML is low, as shown in FIG. 13B, the area of the first inclined surface SS1 can be set to be greater than the area of the second inclined surface SS2, thereby optimizing the lifespan between pixels to improve luminance, power consumption, etc., to secure product competitiveness. Conversely, when the luminance of the green light emitting layer G-EML is low, although not shown, it is possible to secure competitiveness of the product such as luminance and power consumption by optimizing lifespan between pixels by making the area of the second inclined surface SS2 greater than the area of the first inclined surface SS1.

In this way, the difference in efficiency and lifespan between the red organic light emitting device and the green organic light emitting device can be compensated for by differentiating the inclined surfaces SS1 and SS2 on both sides of the stripe pattern STP.

As another example, the stripe pattern STP can have a square shape (FIG. 13c).

For example, the stripe pattern STP can have a first inclined surface SS1, a second inclined surface SS2, and an upper surface TM. In this case, the first inclined surface SS1 and/or the second inclined surface SS2 can have a right angle to the horizontal line. That is, the first inclined surface SS1 can have a right angle to the horizontal line. The second inclined surface SS2 can have a right angle to the horizontal line. For example, the internal angle of the first inclined surface SS1 with respect to the plane and the internal angle of the second inclined surface SS2 with respect to the plane can be the same or different. Both the internal angle of the first inclined surface SS1 with respect to the plane and the internal angle of the second inclined surface SS2 with respect to the plane can have right angles. An internal angle of the first inclined surface SS1 with respect to the plane can have a right angle, and an internal angle of the second inclined surface SS2 with respect to the plane can have an angle smaller than 90 degrees. An internal angle of the second inclined surface SS2 with respect to the plane can have a right angle, and an internal angle with respect to the first inclined surface SS1 can have an angle smaller than 90 degrees.

The length of the first inclined surface SS1 or the second inclined surface SS2 can be the same as or different from the length of the upper surface TM. The length of the first inclined surface SS1 or the second inclined surface SS2 can be equal to or greater than the length of the upper surface TM. The area of the first inclined surface SS1, the area of the second inclined surface SS2, and the area of the upper surface TM can be the same or different. The area of the first inclined surface SS1 or the second inclined surface SS2 can be equal to or greater than the area of the upper surface TM. The length of the first inclined surface SS1 and the length of the second inclined surface SS2 can be the same or different. The area of the first inclined surface SS1 and the area of the second inclined surface SS2 can be the same.

In FIG. 13C, the stripe pattern STP can have a first inclined surface SS1 and/or a second inclined surface SS2 perpendicular to the ground. Also, the stripe pattern STP can have an upper surface. Although not shown, internal angles of the first inclined surface SS1 and/or the second inclined surface SS2 with respect to the ground can have an obtuse angle, that is, an angle greater than or equal to 90 degrees. When the internal angles of the first inclined surface SS1 and/or the second inclined surface SS2 with respect to the ground have an obtuse angle, the stripe pattern STP can have an inverse tapered shape.

In an embodiment, the internal angle of the first inclined surface SS1 and/or the second inclined surface SS2 of the stripe pattern STP can be 60 degrees to 95 degrees, but is not limited thereto.

A red light emitting layer R-EML can be disposed on the first inclined surface SS1 and a green light emitting layer G-EML can be disposed on the second inclined surface SS2. In this case, as the interval between the red light emitting layer R-EML and the green light emitting layer G-EML is narrow, it is advantageous in terms of miniaturization and high PPI. Therefore, it is desirable to minimize the length or area of the upper surface TM.

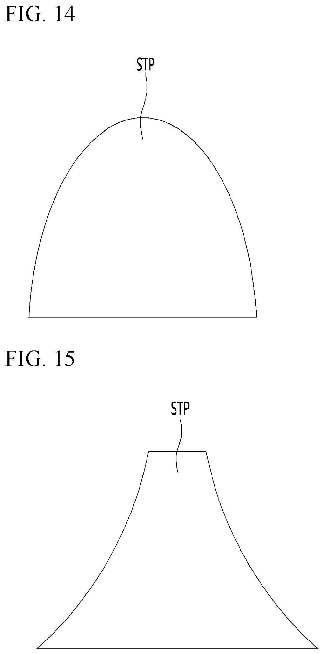

Referring to FIG. 14, the stripe pattern STP can be a curved inclined surface and can be configured to have an outwardly convex inclined surface.

Referring to FIG. 15, the stripe pattern STP can be a curved inclined surface and can be configured to have an inwardly concave inclined surface.

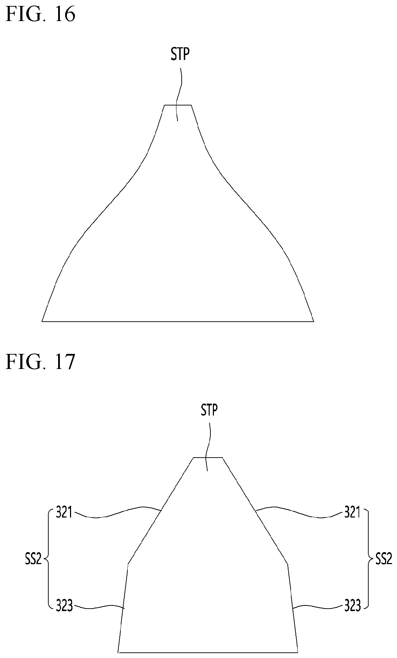

Referring to FIG. 16, the stripe pattern STP can be a curved inclined surface and can be configured to have a convex part and a concave part.

Referring to FIG. 17, the stripe pattern STP can have a polygonal shape. The stripe pattern STP can have a first inclined surface SS1, a second inclined surface SS2, and an upper surface TM. Although the drawing shows that the first inclined surface SS1 and the second inclined surface SS2 are symmetrical to each other with respect to the vertical line, they can be asymmetrical to each other.

For example, the first inclined surface SS1 can have a plurality of first sub-inclined surfaces 311 and 312. Internal angles between the plurality of first sub- inclined surfaces 311 and 312 can be the same as or different from each other. For example, the second inclined surface SS2 can have a plurality of second sub-inclined surfaces 321 and 322.

Internal angles between the plurality of second sub-inclined surfaces 321 and 322 can be the same as or different from each other. For example, the red light emitting layer R-EML can be disposed on the plurality of first sub-inclined surfaces 311 and 312. For example, the green light emitting layer G-EML can be disposed on the plurality of second sub-inclined surfaces 321 and 322. In this case, red light can be emitted in different directions by the red light emitting layers R-EML disposed on the plurality of first sub- inclined surfaces 311 and 312 having different internal angles. In addition, green light can be emitted in different directions by the green light emitting layer G-EML disposed on the plurality of second sub-inclined surfaces 321 and 322 having different internal angles. Accordingly, the red light R-EML or the green light G-EML can be emitted at a larger radiation angle so that a high-brightness and high-definition image can be displayed. For example, there is an advantage in that a high-definition display device of 2000 PPI or more can be implemented more effectively.

As described above, while the stripe pattern STP of the embodiment can have a tapered shape in which the width is narrowed toward an upper part, the shape of the inclined surface can be variously modified.

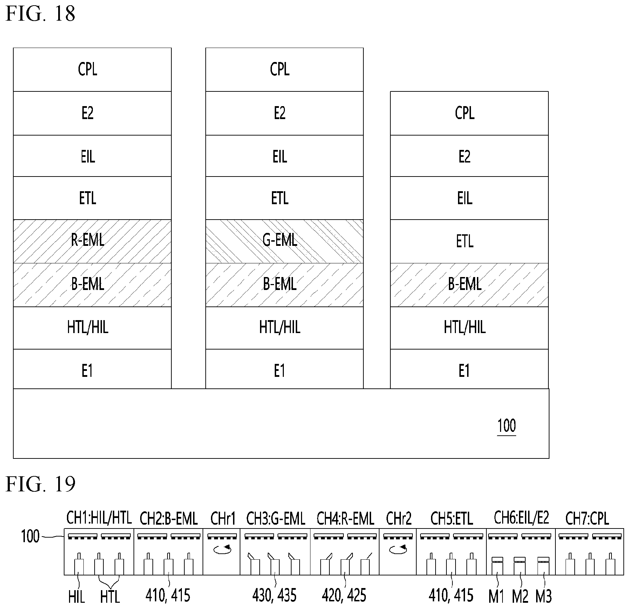

The organic light emitting device of the organic light emitting display device of the embodiment can be manufactured using an in-line deposition apparatus, which will be described in detail below. Unlike this, the embodiment can be adopted for a cluster method when a structure or design for each chamber is changed to be similar or identical to that of the in-line method. That is, when each chamber is deformed so that the moving direction of the substrate 100 or the moving direction of the evaporation source in a specific organic light emitting layer can be similar, for example, a red organic light emitting layer R-EML or a green organic light emitting layer G-EML, the in-line type deposition apparatus can be equally applied to the cluster type deposition apparatus. FIG. 18 is a diagram showing a stacked structure for each organic light emitting device according to the first embodiment. FIG. 19 is a diagram schematically showing an in-line deposition apparatus for forming the organic light emitting device of the stacked structure of FIG. 18.

In the structure of the organic light emitting device shown in FIGS. 1 and 18, in each of the red, green, and blue subpixels SPr, SPg and SPb, a blue light emitting layer B-EML, a hole injection layer HIL and/or hole transport layer HTL below the blue light emitting layer B-EML. and an electron transport layer ETL and/or an electron injection layer EIL on the blue light emitting layer B-EML ca be commonly formed, and a capping layer CPL can be commonly formed on a second electrode E2. The arrangement order of the hole injection layer HIL and the hole transport layer HTL can also be changed. In addition, the arrangement order of the electron transport layer ETL and the electron injection layer EIL can be changed. As described above, the hole injection layer HIL and/or hole transport layer HTL can be included in a hole transport structure, the electron transport layer ETL and the electron injection layer EIL can be included in an electron transport structure, and the hole transport structure and the electron transport structures can each comprise more organic layers than these.

Meanwhile, the red light emitting layer R-EML can be formed on the blue light emitting layer B-EML in the red subpixel SPr, and the green light emitting layer G-EML can be formed on the blue light emitting layer B-EML in the green subpixel SPg.

In order to implement such a stacked structure, an in-line deposition apparatus shown in FIG. 19 can be used. In contrast, the in-line deposition apparatus can comprise a plurality of deposition chambers for depositing a plurality of stacked films constituting the organic light emitting device, and the first to seventh deposition chambers CH1 to CH7, for example, can be used to move the substrate 100. They can be sequentially arranged along one direction. The in-line deposition apparatus can further comprise a first rotation chamber CHr1 and a second rotation chamber CHr2 for rotating the substrate.

Meanwhile, although not specifically shown, a chamber having a function other than deposition or rotation can be located at the front and/or rear end of at least one of the first to seventh deposition chambers CH1 to CH7 and the first and second rotation chambers CHr1 and CHr2. In addition, the direction of the stripe pattern STP can be changed according to the layout of the panel or the plurality of organic light emitting devices within the substrate 100. Therefore, in the inputting step of the substrate 100, it can be designed to allow the inputting of the substrate 100 in two or more directions.

In the first deposition chamber CH1, a hole injection layer and/or hole transport layers HIL and HTL can be commonly deposited on the substrate 100 on which the stripe pattern STP and the first electrode E1 are formed. At this time, in order to deposit the hole injection layer HIL and/or hole transport layer HTL on the substrate 100 with a uniform thickness, a plurality of first evaporation sources 410 having first nozzles 415 can be disposed in the first deposition chamber CH1.

As another example, in order to give a difference in the thickness of the first inclined surface SS1 and/or the second inclined surface SS2, the first evaporation source 410 having a first nozzle 415 perpendicular to the horizontal plane, the second evaporation source 420 having a second nozzle 425 inclined forward and the third evaporation source 430 having a third nozzle 435 inclined backward can be disposed in an appropriate combination.

Meanwhile, in the first deposition chamber CH1, an evaporation source for depositing the hole injection layer HIL can be disposed on a carrying-in side of the substrate, and an evaporation source for depositing the hole transport layer HTL can be disposed on a carrying-out side of the substrate.

In the second deposition chamber CH2, a blue light emitting layer B-EML can be commonly deposited on the substrate 100. At this time, a plurality of first evaporation sources 410 having first nozzles 415 vertical to the ground can be disposed in the second deposition chamber CH2. Accordingly, the blue light emitting layer B-EML can be continuously formed with a substantially uniform thickness in the blue, red, and green subpixels SPb, SPr, and SPg. In addition, in each of the first deposition chamber CH1 and the second deposition chamber Ch2, the substrate 100 can be moved in a direction (X-axis direction) perpendicular to the column direction (Y-axis direction) in which the stripe pattern STP extends in the same manner as the third and fourth deposition chambers CH3 and CH4. In this case, the hole transport layer HTL and the blue organic light emitting layer B-EML, which are common layers, can be deposited with different thicknesses for each of the red subpixel SPr, the green subpixel SPg, and the blue subpixel SPb. As a result, a deposition technique with an improved degree of freedom can be secured to improve performance of each of the red organic light emitting device, the green organic light emitting device, and the blue organic light emitting device. Accordingly, a new device with improved performance can be implemented. In this case, the first rotation chamber CHr1 can be unnecessary and can be omitted.

The substrate 100 on which the blue light emitting layer B-EML is formed in the second deposition chamber CH2 can be put into the first rotation chamber CHr1 and rotated.

In this regard, for example, as mentioned above, during the deposition process in the first and second deposition chambers CH1 and CH2, the substrate 100 can move in parallel with the column direction in which the stripe pattern STP extends. For the substrate 100, a process of rotating the substrate 100 by 90 degrees can be performed prior to the deposition process of the green and red light emitting layers G-EML and R-EML, which is a subsequent process. A first rotation chamber CHr1 can be provided.

The substrate 100 rotated by 90 degrees by the first rotation chamber CHr1 can be put into the third deposition chamber CH3, and a corresponding deposition process can be performed while the substrate 100 is moved parallel to the row direction perpendicular to the stripe pattern STP. In this regard, in the third deposition chamber CH3, a green light emitting layer G-EML can be deposited on the green subpixel SPg on the substrate 100. At this time, a plurality of third evaporation sources 430 having third nozzles 435 inclined backward can be disposed in the third deposition chamber CH3.

In the fourth deposition chamber CH4, a red light emitting layer R-EML can be deposited on the red subpixel SPr on the substrate 100. At this time, a plurality of second evaporation sources 420 having second nozzles 425 inclined forward can be disposed in the fourth deposition chamber CH4.

The substrate 100 on which the red light emitting layer R-EML can be formed in the fourth deposition chamber CH4 can be put into the second rotation chamber CHr2 and rotated.

In this regard, for example, in the third and fourth deposition chambers CH3 and CH4, the deposition process proceeds while the substrate 100 is moved along the row direction, and before the subsequent deposition process, a process of rotating the substrate 100 by 90 degrees can be performed. A second rotation chamber CHr2 can be provided for a rotation process of the substrate.

The substrate 100 rotated by 90 degrees by the second rotation chamber CHr2 can be put into the fifth deposition chamber CH5, and a corresponding deposition process can be performed while the substrate 100 is moved parallel to the column direction in which the stripe pattern STP extends.

In this regard, in the fifth deposition chamber CH5, the electron transport layer ETL can be commonly deposited on the substrate 100. At this time, a plurality of first evaporation sources 410 having first nozzles 415 can be disposed in the fifth deposition chamber CH5. As another example, the first evaporation source 410 having a first nozzle 415, the second evaporation source 420 having a second nozzle 425, and the third evaporation source 430 having a third nozzle 435 together can be disposed.

In the sixth deposition chamber CH6, the electron injection layer EIL/second electrode E2 can be commonly deposited on the substrate 100. At this time, in the sixth deposition chamber CH6, an evaporation source M1 of an inorganic material (or metal) for the electron injection layer and an evaporation source M2, M3 of an inorganic material (or metal) for the second electrode can be used so that the electron injection layer EIL and the second electrode E2 can be commonly deposited on the substrate 100.

In the seventh deposition chamber CH7, the capping layer CPL can be commonly deposited on the substrate 100. At this time, a plurality of first evaporation sources 410 having first nozzles 415 can be disposed in the seventh deposition chamber CH7. As another example, the first evaporation source 410 having a first nozzle 415, the second evaporation source 420 having a second nozzle 425, and the third evaporation source 430 having a third nozzle 435 together can be disposed.

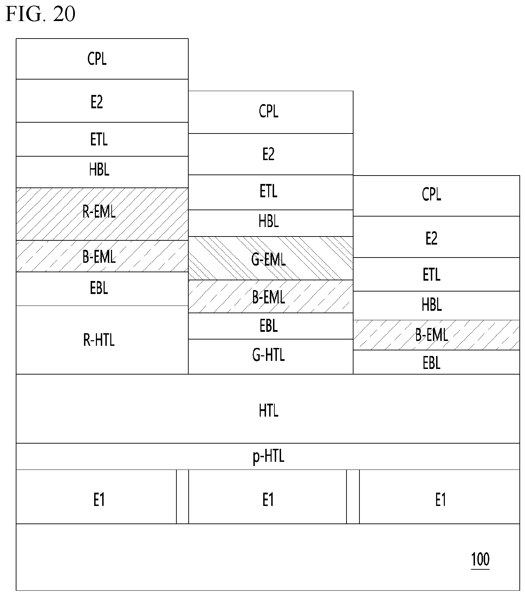

FIG. 20 is a diagram showing a stacked structure for each organic light emitting device according to a second embodiment.

In the structure of the organic light emitting device shown in FIGS. 1, 3 and 20, a p-hole transport layer p-HTL and a hole transport layer HTL can be commonly deposited on the substrate 100 on which the stripe pattern STP and the first electrode E1 are formed. The p-hole transport layer p-HTL can be a hole injection layer doped with a p-type dopant. Unless otherwise specified, the p-hole transport layer p-HTL described below can refer to a hole injection layer.

A red hole transport layer R-HTL and a green hole transport layer G-HTL can be individually deposited on the red subpixel SPr and the green subpixel SPg, respectively.

An electron blocking layer EBL can be commonly deposited on the substrate 100. The electron blocking layer EBL can be an inorganic semiconductor layer, but is not limited thereto.

A blue light emitting layer B-EML can be commonly deposited on the substrate 100.

A green light emitting layer G-EML and a red light emitting layer R-EML can be individually deposited on the green subpixel SPg and the red subpixel SPr, respectively.

A hole blocking layer HBL can be commonly deposited on the substrate 100.

An electron transport layer ETL can be commonly deposited on the substrate 100.

A second electrode E2 can be commonly deposited on the substrate 100.

A capping layer CPL can be commonly deposited on the substrate 100.

Although the above description is based on processes in chronological order, the processes can be simultaneously performed or the order of processes can be changed in time.

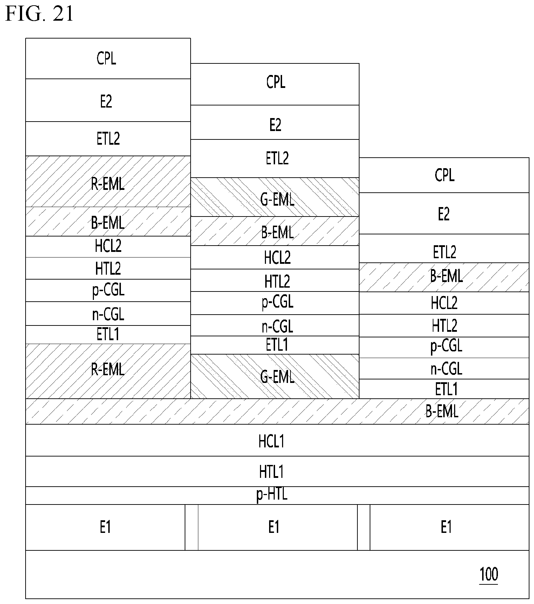

In order to form the stacked structure of the organic light emitting device of FIG. 21, an in-line deposition apparatus similar to the in-line deposition apparatus of FIG. 19 can be used.

FIG. 21 is a diagram showing a stacked structure for each organic light emitting device according to a third embodiment.

The stacked structure for each organic light emitting device shown in FIGS. 1, 3, and 21 can be a so-called two-stack structure, in which two light emitting layers of a corresponding color are stacked in each subpixel SP.

In this regard, the p-hole transport layer p-HTL and the hole transport layer HTL1 can be commonly deposited on the substrate 100 on which the stripe pattern STP and the first electrode E1 are formed. The p-hole transport layer p-HTL can be a hole injection layer doped with a p-type dopant.

A hole control layer HCL1 can be commonly deposited on the substrate 100.

A blue light emitting layer B-EML can be commonly deposited on the substrate 100.

A green light emitting layer G-EML and a red light emitting layer R-EML can be individually deposited on the green subpixel SPg and the red subpixel SPr, respectively.

An electron transport layer ETL1 can be commonly deposited on the substrate 100.

An n-charge generation layer n-CGL can be commonly deposited on the substrate 100.

A p-charge generation layer p-CGL can be commonly deposited on the substrate 100.

Another hole transport layer HTL2 can be commonly deposited on the substrate 100.

Another hole control layer HCL2 can be commonly deposited on the substrate 100.

A blue light emitting layer B-EML can be commonly deposited on the substrate 100.

A green light emitting layer G-EML and a red light emitting layer R-EML can be individually deposited on the green subpixel SPg and the red subpixel SPr, respectively.

Another electron transport layer ETL2 can be commonly deposited on the substrate 100.

A second electrode E2 can be commonly deposited on the substrate 100.

A capping layer CPL can be commonly deposited on the substrate 100.

The first electrode E1 can be separately disposed in each of the red subpixel SPr, the green subpixel SPg, and the blue subpixel SPb. The second electrode E2 can be commonly disposed in the red subpixel SPr, the green subpixel SPg, and the blue subpixel SPb. For example, the first electrode E1 can be an anode electrode and the second electrode E2 can be a cathode electrode.

The two-stack structure can be a structure in which at least two or more organic light emitting layers R-EML, G-EML and B-EML emitting light of the same color above and below the n-charge generation layer n-CGL and the p- charge generation layer p-CGL can be disposed. A plurality of organic layers can be disposed above and below the n-charge generation layer n-CGL and the p-antigen generation layer p-CGL, respectively.

Although the above description is based on processes in chronological order, the processes can be simultaneously performed or the order of processes can be changed in time. In order to form the stacked structure of the organic light emitting device of FIG. 21, an in-line deposition apparatus similar to the in-line deposition apparatus of FIG. 19 can be used.

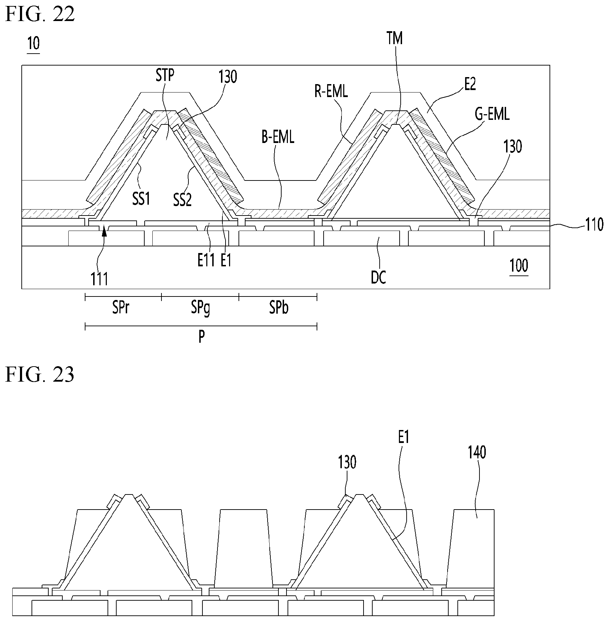

FIG. 22 is a diagram schematically showing an organic light emitting display device according to a second embodiment. In FIG. 22, for convenience of explanation, the stripe pattern and the light emitting layer are mainly shown, and other components are omitted.

Referring to FIG. 22, in the organic light emitting display device 10 of the embodiment, a protection pattern 130 covering the corner of the first electrode E1 can be formed compared to the organic light emitting display device of the first embodiment.

In this regard, a step difference can be generated by forming the first electrode E1, and in particular, when the first electrode E1 is made of, for example, ITO/Ag/ITO and can have a reflective function, the step difference can increase as the thickness increases.

An overcurrent can be formed by such the step difference, and in this case, an electrical short can occur between the first electrode E1 and the second electrode E2.

In order to improve this, a protective pattern 130 covering each corner of the first electrode E1 can be formed. An electrical short between the first electrode E1 and the second electrode E2 can be resolved by reducing the step difference by the protective pattern 130.

FIG. 23 can be referred to in relation to the method of forming the protective pattern 130.

Referring to FIG. 23, a first electrode E1 can be formed in each subpixel through a photolithography process, and then a photoresist pattern 140 serving as an etching mask for forming the first electrode E1 can be ashed.

Accordingly, the corner of the first electrode E1 of each subpixel SP can be exposed without being covered by the photoresist pattern 140. For example, the corner of about 1 μm or more can be exposed.

After that, the substrate 100 can be immersed in the electrolyte and a voltage can be applied to the first electrode E1 through the driving circuit DC of the subpixel SP. Accordingly, a protective pattern 130 can be formed by electrodepositing an organic insulating material or an inorganic insulating material on the exposed corner of the first electrode E1.

After forming the protective pattern 130, the photoresist pattern 140 can be removed, and then an organic light emitting layer can be formed.

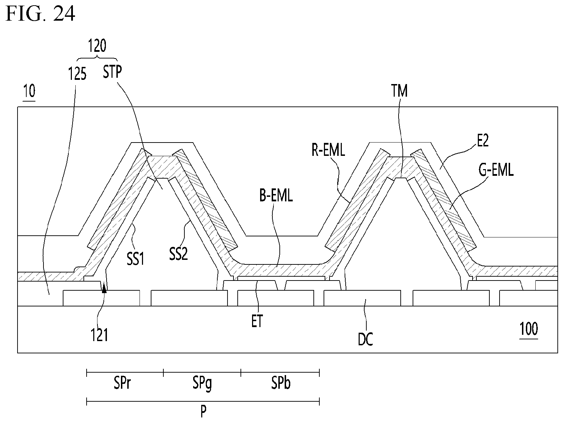

FIG. 24 is a diagram schematically showing an organic light emitting display device according to a third embodiment. In FIG. 24, for convenience of description, the stripe pattern and the light emitting layer are mainly shown, and other components are omitted.

Referring to FIG. 24, in the organic light emitting display device 10 of the embodiment, compared to the organic light emitting display device of the first embodiment, A protective layer 120 in which the planarization layer 125 and the stripe pattern STP are integrated can be formed on the drive circuit DC.

In this regard, for example, an organic insulating material can be deposited on the substrate 100 on which the driving circuit (DC) is formed and a photolithography process can be performed to form the protective layer 120 composed of the stripe pattern STP and the planarization layer 125.

The stripe pattern STP can be configured similarly to the stripe patterns of the first and second embodiments, and can be formed to correspond to the red subpixel SPr and the green subpixel SPg.

The planarization layer 125 connecting the adjacent stripe patterns STP can be formed between the adjacent stripe patterns STP. The planarization layer 125 can be substantially positioned to correspond to the blue subpixel SPb.

Meanwhile, a contact hole 121 exposing one electrode of the driving circuit DC of each subpixel SP can be formed in the protective layer 120.

In this regard, for example, the contact hole 121 exposing the driving circuit DC of the red subpixel SPr can be formed at a boundary between the first inclined surface SS1 of the stripe pattern STP and the planarization layer 125 adjacent thereto.

The contact hole 121 exposing the driving circuit DC of the green subpixel SPg can be formed at a boundary between the second inclined surface SS2 of the stripe pattern STP and the planarization layer 125 adjacent thereto.

In addition, the contact hole 121 exposing the driving circuit DC of the blue subpixel SPb can be formed in the planarization layer 125.

On the protective layer 120 as above, the first electrode E1 can be formed for each subpixel SP. The first electrode E1 of each subpixel SP can be connected to the corresponding driving circuit DC through the corresponding contact hole 121.

The first electrode E1 as described above can be configured similarly to the first electrode E1 of the first and second embodiments.

Meanwhile, although not specifically showed, the protective pattern of the second embodiment can be applied to the organic light emitting display device 10 of the third embodiment. In this regard, after forming the first electrode E1, a protective pattern covering the corner thereof can be formed.

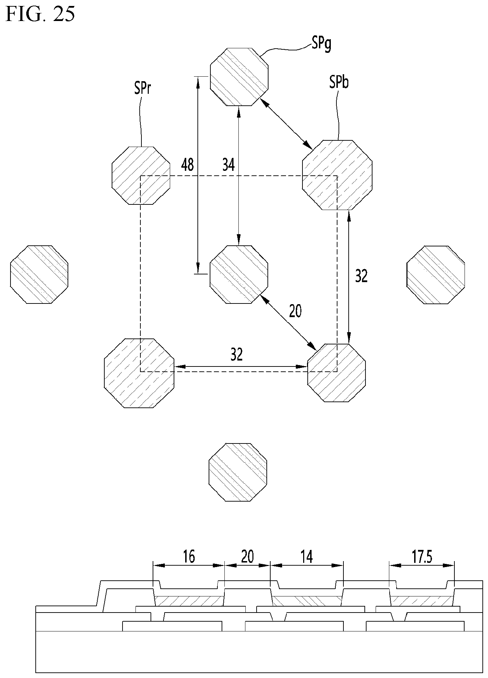

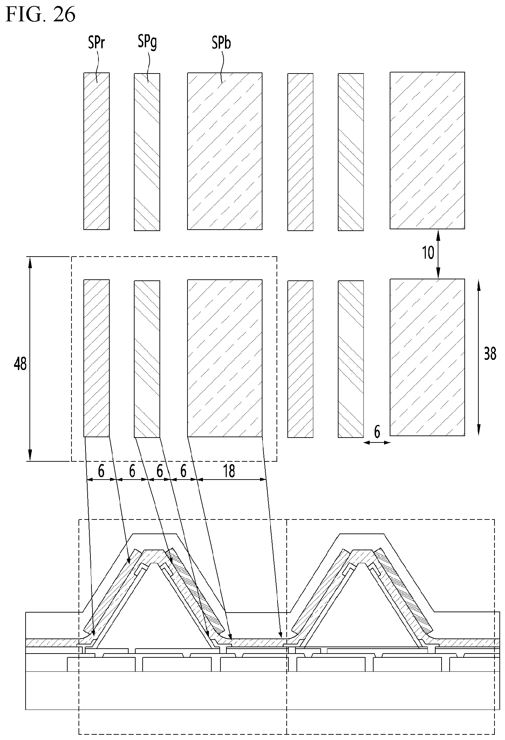

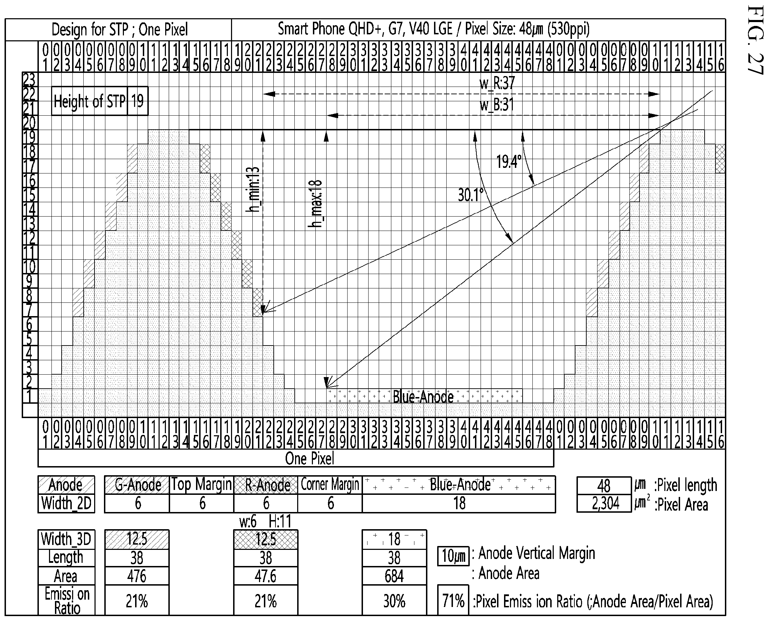

Table 1 shows a product as an organic light emitting display device having a stripe pattern according to an embodiment, design values of the stripe pattern, and prediction results of product performance. Table 2 shows a comparison result of a display device of a related art and a display device having a stripe pattern of an embodiment in a phone display product. FIG. 25 is a diagram schematically showing a pixel structure of a general display device. FIG. 26 is a diagram schematically showing a pixel structure of a display device according to an embodiment (See Table 2). FIG. 27 is a diagram schematically showing a design model of a pixel of the display device of the embodiment of FIG. 26. Meanwhile, in FIGS. 25 and 26, the units of numbers can be "μm". The anode electrodes of the red, green, and blue subpixels in FIG. 27 can be not covered by the protective pattern and can be substantially the first electrodes located in the effective light emitting area.

Table 1

| Products | | Pixel | | Design parameter | | | | Product performance prediction | | | |
|---|---|---|---|---|---|---|---|---|---|---|---|
| product family | Spec | PPI (ea./inch) | pixel size ($\mu$m) | STP height ($\mu$m) | STP height/pixel size | Maximum Deposition Angle/Deposition Angle Margin (°) | Top/Corner Margin ($\mu$m) | pixel aperture ratio (%) | | Aperture ratio increase rate (times) | |
| | | | | | | | | Related Art | Embodiment | | |
| ARIVR | 1.3" (2560 x 2560) | 2785 | 9.1 | 3.6 | 40% | 33.7/14.3 | 1.3/1.4 | ~15 | 62 | 4.1 | 7. 2 ~ |
| Phone | 6.5" (3120 x 1440) | 530 | 48 | 19 | 40% | 30.1/10.8 | 6/6 | 23 | 71 | 3.1 | 4. 8 |
| Pad | 9.7" (2048 x 1536) | 264 | 96 | 38 | 40% | 31.8/6.6 | 12/10 | 29 | 93 | 3.2 | 5. 1 |
| TV | 55"(3840 x 2160) | 80 | 318 | 140 | 44% | 32.9/4.9 | 28/19 | 38 | 116 | 3.1 | 4. 8 |

Table 2

| | Product(530ppi) | Related Art | Embodiment |
|---|---|---|---|
| 1 | pixel structure | RGRG, pentile | RGB, fully arrangement |
| 2 | pixel area ($\mu$m$^2$) | 2,304 | |
| 3 | R area, aperture ratio | 286 (6.2%) | 476 (21%) |
| 4 | G 면적, aperture ratio | 219 (9.5%) | 476 (21%) |
| 5 | B 면적, aperture ratio | 322 (7.0%) | 684 (30%) |
| 6 | Pixel aperture ratio | 22.7% | 71% |
| 7 | device lifespan (times) | 1 | 4.8 |

Referring to Table 1, in various products (AR/VR, Phone, Pad, TV), the height of the stripe pattern can be approximately 40% to 44% of the pixel size, and the margin of the deposition angle decreases as the PPI decreases. In the embodiment, by arranging subpixels in at least two areas of a stripe pattern to configure pixels in a three-dimensional manner, the pixel area usage can be dramatically increased. Each of the two areas can have at least one surface, and can be an inclined surface inclined with respect to the ground. By depositing in a self-aligned manner without using a deposition pattern mask such as FMM, it is possible to reduce the interval between subpixels and the interval between pixels, thereby increasing the aperture ratio by about three times or more compared to the related art.

In addition, the lifespan of the display device can be increased by about 4.8 times compared to the related art. In this regard, Equation 3 can be referred to.

$$\text{Equation 3: lifespan ratio} = (\text{aperture ratio})^n \ (n = 1.4)$$

On the other hand, in calculating the pixel aperture ratio of the related art, the width of the bank located between the subpixels is assumed to be 20 $\mu$m. Only when the PPI is 530, the pentile structure (i.e., R, G, B, G arrangement) is be assumed. For the rest of the PPI's, the R, G, B fully arrangement structure was calculated.

Meanwhile, in order to more accurately confirm the improvement of the display device of the embodiment, reference is made to the pixel structure of the display device of the related art and the pixel structure of the embodiment in the 530PPI mobile phone shown in FIGS. 25 and 26. As shown in Fig. 27 based on the design dimensions in Fig. 26, the aperture ratio, maximum deposition angle, deposition angle margin, etc. of the pixel structure of the display device of the embodiment (e.g., the pixel structure of the third embodiment) can be predicted.

Comparing the display device of the related art and the embodiment, it can be seen that the aperture ratio can be increased by about 3.1 times and the lifespan can be increased by about 4.8 times compared to the display device of the related art. In the related art, subpixel areas are differentiated to compensate for differences in lifespan for each color, and a pentile structure can be applied to overcome resolution limitations. On the other hand, it can be confirmed that a new type of organic light emitting display device can be provided because a sufficient design margin is secured for lifespan in the embodiment.

Image quality performance and yield can be optimized by adjusting variables such as the height of the stripe pattern, its top margin, and the top and bottom margins of the first electrode (i.e., top and bottom margins on a plane).

The innovative increase in device lifespan can also increase the luminance of the display device so that the intrinsic performance of the display device can be improved.

Moreover, in the manufacture of the ultra-small organic light emitting display device such as OLEDoS (OLED on Silicon), in which side-by-side arrangement is currently impossible or in a large-area deposition apparatus, evaporation becomes possible without using FMM, opening a new era of the display device.

In addition, since a large-area organic light emitting display device for outdoor use requires improved luminance and improved lifespan, it will be possible for an organic light emitting display device to occupy the market where micro LEDs are currently used.

In addition, if the structure of the embodiment is applied to the side-by-side structure-applied the product of the related art, not only performance innovation but also cost innovation by increasing productivity can be possible, which will expand the application to laptops, monitors, automobiles, etc.

As described above, in the display device of the embodiment, two subpixels constituting a pixel can be positioned on a stripe pattern, an organic light emitting layer generating color light from another subpixel constituting a pixel located in a separation area between the adjacent stripe patterns can be deposited, and an organic light-emitting layer generating color light of each of two subpixels can be individually deposited on both inclined surfaces of the stripe pattern in a self-aligning manner.

Accordingly, it is possible to form subpixels in a side-by-side structure for a high-definition or large-area display device that is difficult to manufacture with FMM, thereby improving performance of the display device such as power consumption, luminance, and lifespan.

Since the side-by-side structure can be implemented through an in-line method, the investment cost can be reduced and the productivity can be improved (e.g., approximately 3 times or more).

In addition, since the light emitting layer can be formed without using FMM, the yield can be improved and the manufacturing cost can be reduced.

In addition, the pixel can have a three-dimensional structure instead of a planar structure so that the light emitting area can be widened and the lifespan can be improved (e.g., about 4 times or more).

Meanwhile, in the first to third embodiments, stacked structures have been described for each of the various organic light emitting devices.

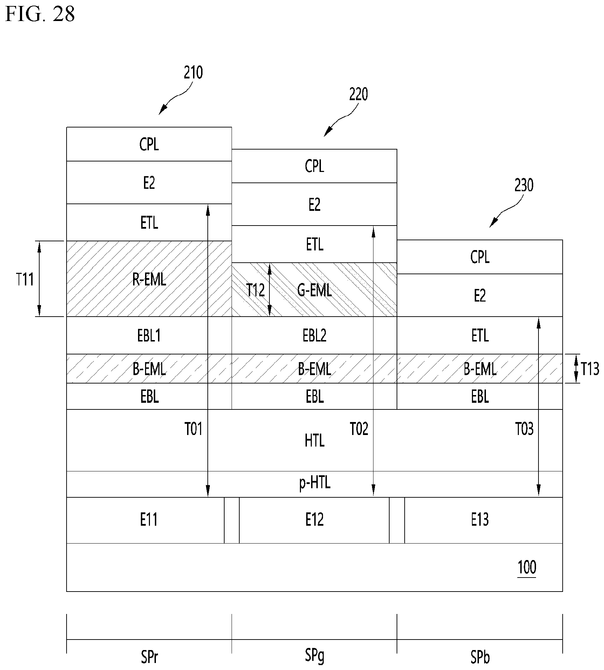

In addition, with reference to FIGS. 28 to 37, more stacked structures for each organic light emitting device will be described.

FIG. 28 is a diagram showing a stacked structure for each organic light emitting device according to a fourth embodiment.

In the fourth embodiment, the same reference numerals are given to components having the same structure, shape and/or function as those in the second embodiment (Fig. 20), and detailed descriptions are omitted. The components omitted below can be easily understood from the foregoing description.

Referring to FIGS. 1, 3 and 28, a plurality of stripe patterns STP can be disposed on the substrate 100. In the substrate 100, the stripe pattern STP can be alternately disposed along a row direction, and the adjacent stripe patterns STP can be spaced apart from each other along a row direction. Accordingly, the substrate 100 can have a separation area between the adjacent stripe patterns STP. The stripe pattern STP can have at least two or more surfaces, respectively. For example, the stripe pattern STP can have a first inclined surface SS1, a second inclined surface SS2, and an upper surface TM.

A red subpixel SPr, a green subpixel SPg, and a blue subpixel SPb constituting the pixel P can be defined on the substrate 100. For example, the red subpixel SPr can be positioned on the first inclined surface SS1 of the stripe pattern STP, the green subpixel SPg can be positioned on the second inclined surface SS2 of the stripe pattern STP, and the blue subpixel SPg can be located in a separation area between the stripe patterns STP.

For example, the red organic light emitting device 210 can be provided in the red subpixel SPr positioned on the first inclined surface SS1 of the stripe pattern STP. For example, the green organic light emitting device 220 can be provided in a green subpixel SPg positioned on the second inclined surface SS2 of the stripe pattern STP. For example, the blue organic light emitting device 230 can be provided in a blue subpixel SPb positioned at a separation area between the adjacent stripe patterns STP.

The blue light emitting layer B-EML can be formed on the entire area of the substrate 100. The blue light emitting layer B-EML can be disposed on the first and second inclined surfaces SS1 and SS2 of the stripe pattern STP and the separation area between the adjacent stripe patterns STP.

A plurality of organic layers, that is, a p-hole transport layer p-HTL/hole transport layer HTL, can be disposed between the blue light emitting layer B-EML and the first electrode E11, E12, and E13. The p-hole transport layer p-HTL can be a hole injection layer doped with a p-type dopant. An electron blocking layer EBL can be disposed as an inorganic semiconductor layer between the blue light emitting layer B-EML and the first electrode E11, E12, and E13, but is not limited thereto. The electron blocking layer EBL can prevent electrons remaining after contributing to the light emission of the blue light emitting layer B-EML from being supplied to the hole transport layer HTL or the p-hole transport layer.

The first electrodes E11, E12, and E13 can be separately disposed in the red subpixel SPr, the green subpixel SPg, and the blue subpixel SPb. The P-hole transport layer p-HTL/hole transport layer HTL or the electron blocking layer EBL can be commonly disposed in the red subpixel SPr, the green subpixel SPg, and the blue subpixel SPb, but is not limited thereto. The p-hole transport layer p-HTL can be a hole injection layer doped with a p-type dopant.

A plurality of organic layers, that is, an electron transport layer ETL, can be disposed between the blue light emitting layer B-EML and the second electrode E2. The electron transport layer ETL can be commonly disposed in the red subpixel SPr, the green subpixel SPg, and the blue subpixel SPb, but is not limited thereto.

The red organic light emitting device 210 can comprise a red organic light emitting layer R-EML, the green organic light emitting device 220 can comprise a green organic light emitting layer G-EML, and the blue organic light emitting device 230 can comprise a blue organic light emitting layer B-EML.

As described above, the blue organic light emitting layer B-EML can be disposed on the entire area of the substrate. In contrast, the red organic light emitting layer R-EML can be disposed only on the red subpixel SPr, and the green organic light emitting layer G-EML can be disposed only on the green subpixel SPg. For example, the red organic light emitting layer R-EML can be disposed on the red subpixel SPr positioned on the first inclined surface SS1 of the stripe pattern STP. For example, the green organic light emitting layer G-EML can be disposed on the green subpixel SPg positioned on the second inclined surface SS2 of the stripe pattern STP.

The red organic light emitting layer R-EML and the green organic light emitting layer G-EML can be disposed on the blue organic light emitting layer B-EML.

Meanwhile, in the top emission method, the first electrodes E11, E12, and E13 can be reflective electrodes and the second electrode E2 can be a transflective electrode. The transflective electrode can be made of, for example, an Mg:Ag alloy, but is not limited thereto. In such a top emission type device, the distance d between the first electrode E11, E12, and E13 and the second electrode E2, that is, the total thickness of the organic film, can be designed to satisfy Equation 4 below for each color. As such, the distance d between the first electrode E11, E12, and E13 and the second electrode E2 can be designed to satisfy Equation 4 so that efficiency can be maximized by using constructive interference generated according to the wavelength of light emitted from the red organic light emitting layer R-EML, the green organic light emitting layer G-EML, and the blue organic light emitting layer B-EML.

The constructive interference can occur in each of the red organic light emitting device 210, the green organic light emitting device 220, and the blue organic light emitting device 230. To this end, the distance d between the first electrode E11, E12, and E13 and the second electrode E2 can be designed so that the wavelengths of light of the red organic light emitting layer R-EML, the green organic light emitting layer G-EML, and the blue organic light emitting layer B-EML satisfy Equation 4. In other words, the distance d between the first electrode E11, E12, and E13 and the second electrode E2 in each of the red organic light emitting device 210, the green organic light emitting device 220, and the blue organic light emitting device 230 can be adjusted to be a multiple of the wavelength $\lambda$ of light generated from each of the red organic light emitting device 210, the green organic light emitting device 220, and the blue organic light emitting device 230. This can be expressed as Equation 4.

$$\text{Equation 4 4: } 2nd = m\lambda$$

n can represent an effective refractive index of each of the red organic light emitting device 210, the green organic light emitting device 220, and the blue organic light emitting device 230. d can represent distances between the first electrode E11, E12, and E13 and the second electrode E2 in the red organic light emitting device 210, the green organic light emitting device 220, and the blue organic light emitting device 230, respectively. m can represent an order, and λ can represent a wavelength of light generated from each of the red organic light emitting device 210, the green organic light emitting device 220, and the blue organic light emitting device 230.

As shown in Equation 4, as the wavelength increases, the distance d between the first electrode E11, E12, and E13 and the second electrode E2 can be large in the red organic light emitting device 210, the green organic light emitting device 220, and the blue organic light emitting device 230, respectively.

As an example, the distance d between the first electrode E11, E12, and E13 and the second electrode E2 in the red organic light emitting device 210, the green organic light emitting device 220, and the blue organic light emitting device 230, respectively can be adjusted to the thickness of the electron transport layer (R-HTL, G-HTL in FIG. 20) in the one-stack structure. A one-stack structure can be shown in FIGS. 28 to 32. In FIGS. 28 to 32, the electron transport layer is not shown, but electron transport layers (R-HTL and G-HTL in FIG. 20) can be shown.

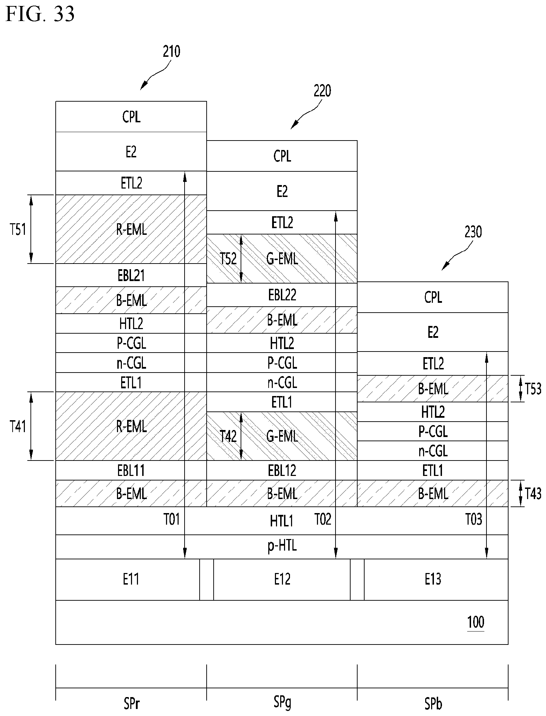

As another example, the distance d between the first electrode E11, E12, and E13 and the second electrode E2 in each of the red organic light emitting device 210, the green organic light emitting device 220, and the blue organic light emitting device 230 can be adjusted to the respective thicknesses T11, T12, and T13 of the two-stack structure. The two-stack structure will be described in detail with reference to FIGS. 33 to 37 later.

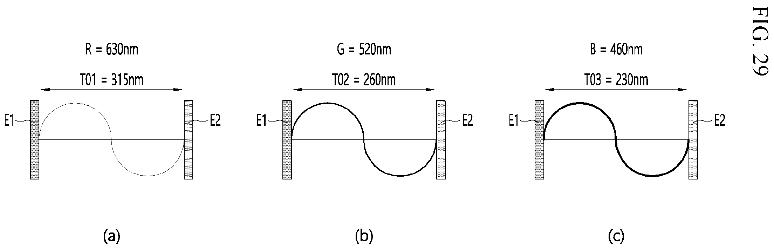

As shown in FIG. 29, since the wavelength of red light is greater than the wavelength of green light or blue light, the distance T01 between the first electrode E11 and the second electrode E2 of the red organic light emitting device 210 can be set to be greater than the distance T02 between the first electrode E12 and the second electrode E2 of the green organic light emitting device 220. Since the wavelength of green light is greater than the wavelength of blue light, the distance T02 between the first electrode E12 and the second electrode E2 of the green organic light emitting device 220 can be set to be greater than the distance T03 between the first electrode E13 of the blue organic light emitting device 230 and the second electrode E2. Accordingly, the red organic light emitting device 210, the green organic light emitting device 220, and the blue organic light emitting device 230 can have different thicknesses T01, T02 and T03.

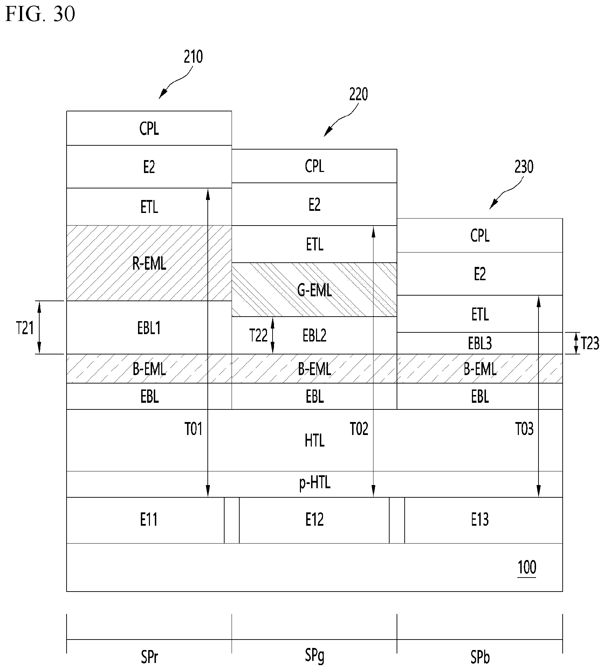

For example, as shown in FIG. 29, the red organic light emitting layer 210, the green organic light emitting device 220, and the blue organic light emitting device 230 have different thicknesses T01, T02 and T03, respectively. The thickness T11 of the red organic light emitting layer R-EML, the thickness T12 of the green organic light emitting layer G-EML, and the thickness T13 of the blue organic light emitting layer B-EML can be adjusted differently. FIG. 29 shows that the thickness T11 of the red organic light emitting layer R-EML, the thickness T12 of the green organic light emitting layer G-EML, and the thickness T13 of the blue organic light emitting layer B-EML can be adjusted. However, the thickness of at least one organic layer among the plurality of organic layers between the first electrode E11, E12, and E13 and the second electrode E2 can be adjusted. Adjusting the thickness of these various layers will be described in detail with reference to FIGS. 30 to 37.

As shown in FIG. 29, when the wavelength of the red organic light emitting layer R-EML is 630 nm, the thickness T01 of the red organic light emitting layer R-EML can be 315 nm. When the wavelength of the green organic light emitting layer G-EML is 520 nm, the thickness T02 of the green organic light emitting layer G-EML can be 260 nm. When the wavelength of the blue organic light emitting layer B-EML is 460 nm, the thickness T03 of the blue organic light emitting layer T03 can be 230 nm.

As described above, by adjusting the thicknesses T01, T02 and T03 of the red organic light emitting device 210, the green organic light emitting device 220, and the blue organic light emitting device 230, respectively so that the wavelength of red light, the wavelength of green light, and the wavelength of blue light generated in each of the red organic light emitting layer R-EML, the green organic light emitting layer G-EML, and the blue organic light emitting layer B-EML can be m multiples, constructive interference can be generated so that the micro cavity effect can be maximized. Accordingly, it is possible to implement a high luminance display device.

Meanwhile, the red organic light emitting device 210 and the green organic light emitting device 220 can comprise an electron blocking layer EBL1 and EBL2, respectively.

For example, the red organic light emitting device 210 can comprise a first electron blocking layer EBL1. The first electron blocking layer EBL1 can be disposed between the blue organic light emitting layer B-EML and the red organic light emitting layer R-EML. The first electron blocking layer EBL1 can prevent electrons remaining after contributing to light emission in the red organic light emitting layer R-EML from passing to the blue organic light emitting layer B-EML. When the first electron blocking layer EBL1 is not provided, electrons remaining after contributing to light emission in the red organic light emitting layer R-EML can be supplied to the blue organic light emitting layer B-EML, thereby contributing to the luminescence of the blue organic light emitting layer B-EML. In this case, not only red light but also blue light can be emitted from the red organic light emitting device 210, and the color purity of the red pixel can deteriorate, thereby reducing the color gamut of the product.

For example, the green organic light emitting device 220 can comprise a second electron blocking layer EBL2. The second electron blocking layer EBL2 can be disposed between the blue organic light emitting layer B-EML and the green organic light emitting layer G-EML. The second electron blocking layer EBL2 can prevent remaining electrons remaining after contributing to light emission in the green organic light emitting layer G-EML from passing to the blue organic light emitting layer B-EML. When the second electron blocking layer EBL2 is not provided, electrons remaining after contributing to light emission in the green organic light emitting layer G-EML can be supplied to the blue organic light emitting layer B-EML, thereby contributing to the blue organic light emitting layer B-EML. In this case, not only green light but also blue light can be emitted from the green organic light emitting device 220, and the color purity of the red pixel deteriorates, thereby reducing the color gamut of the product.

In an embodiment, the red organic light emitting device 210 and the green organic light emitting device 220 can comprise a first electron blocking layer EBL1 and a second electron blocking layer EBL2, respectively. Even if the blue organic light emitting layer B-EML is included in the red organic light emitting device 210 and the green organic light emitting device 220, blue light is not emitted from the blue organic light emitting layer B-EML so that an excellent color gamut of the product can be achieved.

Meanwhile, an electron blocking layer EBL can be included in a lower portion of the blue organic light emitting device 230, but an electron blocking layer may not be present in an upper portion of the blue organic light emitting device 230. That is, in the blue organic light emitting device 230, no electron blocking layer is disposed between the blue organic light emitting layer B-EML and the electron transport layer ETL. Accordingly, the supply of electrons from the electron transport layer ETL to the blue organic light emitting layer B-EML is not blocked so that the amount of blue light emitted from the blue organic light emitting layer B-EML increases, thereby improving the efficiency of the device. The luminance can be improved by improving the efficiency of the device.

On the other hand, in the red organic light emitting device 210 or the green organic light emitting device 220, the triplet energy EBL T1 of the material of the electron blocking layers EBL1 and EBL2 and the triplet energy Host T1 of the host of the light emitting layers R-EML and G-EML can satisfy Equation 5 below.

$$\text{Equation 5:} \quad \left| \text{ EBL T1} - \text{Host T1} \right| \geq 0.2 \text{ eV}$$

EBL T1 can represent the triplet energy of the materials of the electron blocking layers EBL1 and EBL2, and Host T1 can represent the triplet energy of the host of the light emitting layers R-EML and G-EML.

FIG. 30 is a diagram showing a stacked structure for each organic light emitting device according to a fifth embodiment.

The fifth embodiment is the same as the fourth embodiment except that the thicknesses of the electron blocking layers EBL1, EBL2, and EBL3 in each of the red organic light emitting layer R-EML, the green organic light emitting layer G-EML, and the blue organic light emitting layer B-EML for constructive interference can be adjusted. In the fifth embodiment, the same reference numerals are given to components having the same structure, shape and/or function as those in the second embodiment (Fig. 20) or the fourth embodiment (Fig. 28) are given same reference numerals, and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a second electron blocking layer can be provided below the hole transport layer HTL so that the second electron blocking layer EBL, the hole transport layer HTL and the electron blocking layer EBL can be configured as a triple layer. Accordingly, each thickness T01, T02 and T03 of the red organic light emitting device 210, the green organic light emitting device 220, and the blue organic light emitting device 230 can be adjusted by the second electron blocking layer EBL, the hole transport layer HTL, and the electron blocking layer EBL.

A hole mobility of the electron blocking layer EBL can be smaller than an electron mobility. In this case, when the thickness of the electron blocking layer EBL is thick, electrons can be well blocked by the electron blocking layer EBL. However, it is difficult for holes to reach the red organic light emitting layer R-EML or the green organic light emitting layer G-EML due to the thick thickness of the electron blocking layer EBL. This causes an increase in the driving voltage of the organic light emitting device. Therefore, the thickness of the electron blocking layer EBL can be thinned to 5 to 25 nm, and the thickness required for optical compensation for constructive interference below the electron blocking layer EBL can be adjusted by adding a hole transport layer HTL.

In addition, by adding an electron blocking layer EBL, that is, a second electron blocking layer below the hole transport layer HTL, it can serve as a double barrier to prevent electrons from reaching the blue organic light emitting layer B-EML included in the red subpixel SPr and the green subpixel SPg. Referring to FIGS. 1, 3, and 30, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

Unlike this, the red organic light emitting device 210 can be disposed on the second inclined surface SS2 of the stripe pattern STP or the separation area between the adjacent stripe patterns STP. The green organic light emitting device 220 can be disposed on the first inclined surface SS1 of the stripe pattern STP or the separation area between the adjacent stripe patterns STP. The blue organic light emitting device 230 can be disposed on the first inclined surface SS1 or the second inclined surface SS2 of the stripe pattern STP.

The red organic light emitting device 210, the green organic light emitting device 220, and the blue organic light emitting device 230 can commonly comprise a blue organic light emitting layer B-EML. The blue organic light emitting layer B-EML can be disposed on the entire area of the substrate 100. For example, the red subpixel SPr, the green subpixel SPg, and the blue subpixel SPb can be commonly disposed. Such structure can be referred to as a blue common structure.

The red organic light emitting device 210 can comprise a red organic light emitting layer R-EML. The red organic light emitting layer R-EML can be disposed on the blue organic light emitting layer B-EML. The green organic light emitting device 220 can comprise a green organic light emitting layer G-EML. The green organic light emitting layer G-EML can be disposed on the blue organic light emitting layer B-EML. The thickness of the red organic light emitting layer R-EML and the thickness of the green organic light emitting layer B-EML can be different. A thickness of the red organic light emitting layer R-EML can be greater than a thickness of the green organic light emitting layer B-EML. A thickness of the green organic light emitting layer B-EML can be greater than a thickness of the red organic light emitting layer R-EML.

Meanwhile, unlike the fourth embodiment (FIG. 28), in the fifth embodiment, the red organic light emitting device 210, the green organic light emitting device 220, and the blue organic light emitting device 230 can comprise electron blocking layers EBL1, EBL2 and EBL3, respectively. That is, in the fourth embodiment (FIG. 28), the blue organic light emitting device 230 may not comprise any electron blocking layer on the blue organic light emitting layer B-EML.

The electron blocking layers EBL1, EBL2, and EBL3 can be commonly disposed on the entire area of the substrate 100. The electron blocking layers EBL1, EBL2, and EBL3 can be commonly disposed in the red subpixel SPr, the green subpixel SPg, and the blue subpixel SPb. Unlike this, the electron blocking layers EBL1, EBL2, and EBL3 can be separated from each of the red subpixel SPr, the green subpixel SPg, and the blue subpixel SPb, and can be disposed only in the corresponding subpixels SPr, SPg and SPb.

The first electron blocking layer EBL1 of the red organic light emitting device 210 can be disposed on the blue organic light emitting layer B-EML. The first electron blocking layer EBL1 can be disposed between the blue organic light emitting layer B-EML and the red organic light emitting layer R-EML, and can prevent electrons remaining after contributing to light emission of the red organic light emitting layer R-EML from being supplied to the blue organic light emitting layer B-EML. Therefore, since blue light is not emitted from the red organic light emitting device 210, the color gamut of the product can be improved.

The second electron blocking layer EBL2 of the green organic light emitting device 220 can be disposed on the blue organic light emitting layer B-EML. The second electron blocking layer EBL2 can be disposed between the blue organic light emitting layer B-EML and the green organic light emitting layer G-EML, and can prevent electrons remaining after contributing to light emission of light emission of the green organic light emitting layer G-EML from being supplied to the blue organic light emitting layer B-EML. Therefore, since green light is not emitted from the green organic light emitting device 220, the color gamut of the product can be improved.

The third electron blocking layer EBL3 of the blue organic light emitting device 230 can be disposed on the blue organic light emitting layer B-EML. The third electron blocking layer EBL3 can be disposed between the blue organic light emitting layer B-EML and the electron transport layer ETL.

Since the blue organic light emitting device 230 need to emit a maximum amount of blue light, the third electron blocking layer EBL3 can be omitted or the smaller the thickness of the third electron blocking layer EBL3, the better. That is, the third electron blocking layer EBL3 may not be included in the blue organic light emitting device 230. Therefore, in the blue organic light emitting device 230, the third electron blocking layer EBL3 on the blue organic light emitting layer B-EML can be omitted.

Meanwhile, the thickness between the first electrode E11, E12, and E12 and the second electrode E2 can be adjusted in each of the red subpixel SPr, the green subpixel SPg, and the blue subpixel SPb so that the micro-cavity effect can be maximized through the constructive interference of light.

Unlike the fourth embodiment (FIG. 28), in the fifth embodiment, the first electron blocking layer EBL1 of the red organic light emitting device 210, the second electron blocking layer EBL2 of the green organic light emitting device 220, and the third electron blocking layer EBL3 of the blue organic light emitting device 230 can be adjusted differently.

In the case of the organic light emitting devices 210, 220, and 230 emitting light having a large wavelength $\lambda$, the distance d between the first electrode E11, E12, and E13 and the second electrode E2 of the organic light emitting devices 210, 220, and 230 can be adjusted to satisfy Equation 4. In order to adjust the distance d between the electrode and the second electrode E2, the thicknesses T21, T22, and T23 of the electron blocking layers EBL1, EBL2, and EBL3 can be set to be larger. Accordingly, the thickness T21 of the first electron blocking layer EBL1 of the red organic light emitting device 210 can be greater than the thickness T22 of the second electron blocking layer EBL2 of the green organic light emitting device 220. The thickness T22 of the second electron blocking layer EBL2 of the green organic light emitting device 220 can be greater than the thickness T23 of the third electron blocking layer EBL3 of the blue organic light emitting device 230.

On the other hand, in order to satisfy Equation 4, the thicknesses T21, T22 and T23 of the electron blocking layers EBL1, EBL2 and EBL3, at least one organic film included in the hole transport structure and/or at least one organic film included in the electron transport structure can be adjusted.

Although not shown, the total thickness of the organic light emitting layers R-EML and G-EML and the electron blocking layers EBL1, EBL2 and EBL3 can be considered as a thickness that is differently adjusted according to the wavelength of light. For example, the total thickness of the red organic light emitting layer R-EML and the first electron blocking layer EBL1 of the red organic light emitting device 210 can be greater than the total thickness of the green organic light emitting layer G-EML and the second electron blocking layer EBL2 of the green organic light emitting device 220. Each thickness of the red organic light emitting layer R-EML and the first electron blocking layer EBL1 can be adjusted within a predetermined total thickness. Each thickness of the green organic light emitting layer G-EMI, and the second electron blocking layer EBL2 can be adjusted within a predetermined total thickness. For example, the total thickness of the green organic light emitting layer G-EMI, and the second electron blocking layer EBL2 of the green organic light emitting device 220 can be greater than the thickness of the third electron blocking layer EBL3 of the blue organic light emitting device 230.

Although not shown, the total thickness of the organic light emitting layer R-EMI, and G-EML, the electron blocking layerEBL1, EBL2 and EBL3 and the blue organic light emitting layer B-EML can be considered as the thickness that is differently adjusted according to the wavelength of light. For example, the total thickness of the red organic light emitting layer R-EML, the first electron blocking layer EBL1 and the blue organic light emitting layer B-EML of the red organic light emitting device 210 can be greater than the total thickness of the green organic light emitting layer G-EML, the second electron blocking layer EBL2, and the blue organic light emitting layer B-EML of the green organic light emitting device 220. Each thickness of the red organic light emitting layer R-EML, the first electron blocking layer EBL1 and the blue organic light emitting layer B-EML can be adjusted within a predetermined total thickness. Each thickness of the green organic light emitting layer G-EML, the second electron blocking layer EBL2, and the blue organic light emitting layer B-EML can be adjusted within a predetermined total thickness. For example, the total thickness of the green organic light emitting layer G-EML, the second electron blocking layer EBL2, and the blue organic light emitting layer B-EML of the green organic light emitting device 220 can be greater than the total thickness of the third electron blocking layer EBL3 and the blue organic light emitting layer B-EML of the blue organic light emitting device 230. The thickness of each of the third electron blocking layer EBL3 and the blue organic light emitting layer B-EML can be adjusted within a predetermined total thickness.

According to the fifth embodiment, the thickness between the first electrode E11, E12, and E12 and the second electrode E2 in each of the red subpixel SPr, the green subpixel SPg, and the blue subpixel SPb, particularly the thickness of each of the first electron blocking layer EBL1, the second electron blocking layer EBL2 and the third electron blocking layer EBL3 can be adjusted differently, respectively. Thus, the microcavity effect can be maximized through the constructive interference of light.

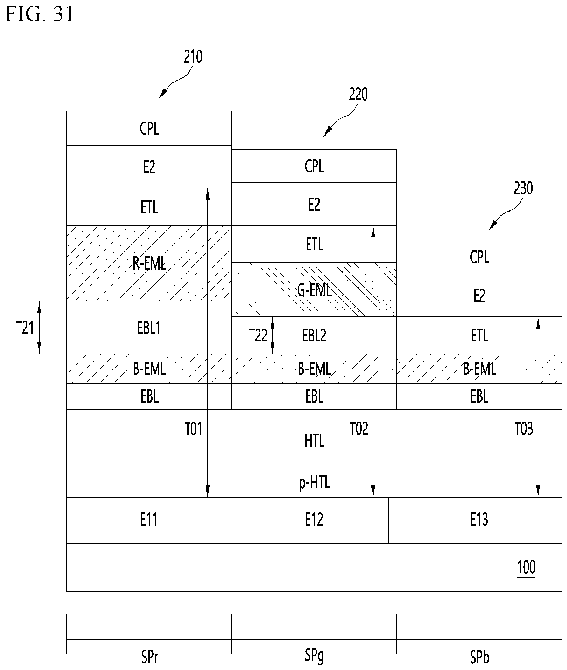

FIG. 31 is a diagram showing a stacked structure for each organic light emitting device according to a sixth embodiment.

The sixth embodiment is the same as the fifth embodiment except that the electron blocking layer is not disposed on the blue subpixel SPb, that is, the blue organic light emitting layer B-EML of the blue organic light emitting device 230. In the sixth embodiment, the same reference numerals are given to components having the same structure, shape and/or function as those in the second embodiment (Fig. 20), the fourth embodiment (Fig. 28) or the fifth embodiment (Fig. 30), and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a second electron blocking layer can be provided below the hole transport layer HTL so that the second electron blocking layer EBL, the hole transport layer HTL and the electron blocking layer EBL can be configured as a triple layer. Accordingly, each thickness T01, T02 and T03 of the red organic light emitting device 210, the green organic light emitting device 220, and the blue organic light emitting device 230 can be adjusted by the second electron blocking layer EBL, the hole transport layer HTL, and the electron blocking layer EBL.

Referring to FIGS. 1, 3, and 31, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

The blue organic light emitting layer B-EML can be commonly disposed in the red subpixel SPr, the green subpixel SPg, and the blue subpixel SPb. That is, each of the red organic light emitting device 210, the green organic light emitting device 220, and the blue organic light emitting device 230 can commonly comprise a blue organic light emitting layer B-EML.

However, in the sixth embodiment, the electron blocking layer may not be disposed on the entire area of the blue organic light emitting layer B-EML. The red organic light emitting device 210 can comprise a first electron blocking layer EBL1. The first electron blocking layer EBL1 can be disposed on the blue organic light emitting layer B-EML. The first electron blocking layer EBL1 can be disposed between the blue organic light emitting layer B-EML and the red organic light emitting layer R-EML. The green organic light emitting device 220 can comprise a second electron blocking layer EBL2. The second electron blocking layer EBL2 can be disposed on the blue organic light emitting layer B-EML. The second electron blocking layer EBL2 can be disposed between the blue organic light emitting layer B-EML and the green organic light emitting layer G-EML.

Unlike this, the blue organic light emitting device 230 may not comprise any electron blocking layer on the blue organic light emitting layer B-EML. That is, in the blue organic light emitting device 230, no electron blocking layer can be disposed between the blue organic light emitting layer B-EML and the electron transport layer ETL. Accordingly, electrons of the electron transport structure including the electron transport layer ETL can be smoothly supplied to the blue organic light emitting layer B-EML without interference, and blue light having a greater amount of light can be emitted from the blue organic light emitting layer B-EML so that the efficiency of the device can be improved. The luminance can be improved by improving the efficiency of the device.

On the other hand, as described above, by adjusting the thickness of the electron blocking layers EBL1 and EBL2 differently, it is possible to maximize the microcavity through the constructive interference.

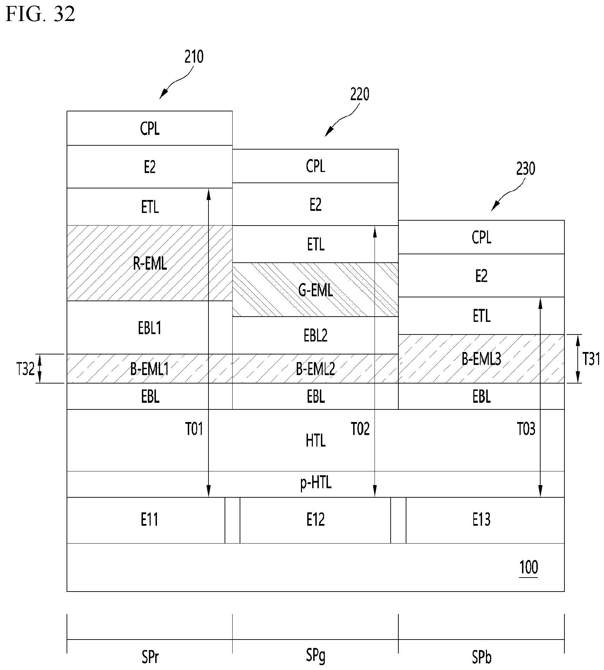

FIG. 32 is a diagram showing a stacked structure for each organic light emitting device according to a seventh embodiment.

The seventh embodiment is the same as the sixth embodiment except that the thickness of the blue organic light emitting layer B-EML is different for each subpixel SPr, SPg and SPb. In the seventh embodiment, the same reference numerals are given to components having the same structure, shape and/or function as those in the second embodiment (Fig. 20), the fourth to sixth embodiments (FIGS. 28, 30 and 31), and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a second electron blocking layer can be provided below the hole transport layer HTL so that the second electron blocking layer EBL, the hole transport layer HTL and the electron blocking layer EBL can be configured as a triple layer. Accordingly, each thickness T01, T02 and T03 of the red organic light emitting device 210, the green organic light emitting device 220, and the blue organic light emitting device 230 can be adjusted by the second electron blocking layer EBL, the hole transport layer HTL, and the electron blocking layer EBL.

Referring to FIGS. 1, 3, and 32, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

The blue organic light emitting layer B-EML can be commonly disposed in the red subpixel SPr, the green subpixel SPg, and the blue subpixel SPb. That is, each of the red organic light emitting device 210, the green organic light emitting device 220, and the blue organic light emitting device 230 can commonly comprise a blue organic light emitting layer B-EML.

For example, the first blue organic light emitting layer B-EML1 can be disposed on the red subpixel SPr. For example, the second blue organic light emitting layer B-EML2 can be disposed on the green subpixel SPg. For example, the third blue organic light emitting layer B-EML3 can be disposed on the blue subpixel SPb. The first blue organic light emitting layer B-EML1, the second blue organic light emitting layer B-EML2, and the third blue organic light emitting layer B-EML3 can be connected to each other. The first blue organic light emitting layer B-EML1, the second blue organic light emitting layer B-EML2, and the third blue organic light emitting layer (B-EML3) can be disposed on the same plane.

Meanwhile, the first blue organic light emitting layer B-EML1, the second blue organic light emitting layer B-EML2, and the third blue organic light emitting layer B-EML3 can have different thicknesses T31 and T32. For example, the thickness T32 of the first blue organic light emitting layer B-EML1 of the red organic light emitting device 210 can be smaller than the thickness T31 of the third blue organic light emitting layer B-EML3 of the blue organic light emitting device 230.

For example, the thickness T32 of the first blue organic light emitting layer B-EML1 of the red organic light emitting device 210 can be 70% or less of the thickness T31 of the third blue organic light emitting layer B-EML3 of the blue organic light emitting device 230. For example, the thickness T32 of the second blue organic light emitting layer B-EML2 of the green organic light emitting device 220 can be smaller than the thickness T31 of the third blue organic light emitting layer B-EML3 of the blue organic light emitting device 230. For example, the thickness T32 of the second blue organic light emitting layer B-EML2 of the green organic light emitting device 220 can be 70% or less of the thickness T31 of the third blue organic light emitting layer B-EML3 of the blue organic light emitting device 230. Although the drawing shows that the thickness of the first blue organic light emitting layer B-EML1 of the red organic light emitting device 210 and the thickness of the second blue organic light emitting layer B- EML2 of the green organic light emitting device 220 can be the same, they can have different thicknesses. For example, the thickness of the first blue organic light emitting layer B-EML1 of the red organic light emitting device 210 can be greater than the thickness of the second blue organic light emitting layer B-EML2 of the green organic light emitting device 220.

The first blue organic light emitting layer B-EML1 of the red organic light emitting device 210 or the second blue organic light emitting layer B-EML2 of the green organic light emitting device 220 can generate blue light when electrons and holes are supplied.

In order to solve this problem, in the sixth embodiment, by minimizing the thickness of the first blue organic light emitting layer B-EML1 of the red organic light emitting device 210 or the second blue organic light emitting layer B-EML2 of the green organic light emitting device 220, generation of blue light from the red organic light emitting device 210 or the green organic light emitting device 220 can be suppressed. Accordingly, only red light can be emitted from the red organic light emitting device 210 and only green light can be emitted from the green organic light emitting device 220.

Meanwhile, in the blue organic light emitting device 230, the efficiency of the device can be improved by increasing the thickness of the third blue organic light emitting layer B-EML3. The luminance can be improved by improving the efficiency of the device.

Meanwhile, when constructive interference is considered, as the thickness of the first blue organic light emitting layer B-EML1 of the red organic light emitting device 210 decreases, the thickness of the first electron blocking layer EBL1 and/or the thickness of the red organic light emitting layer R-EML can be adjusted to increases.

When constructive interference is considered, as the thickness of the second blue organic light emitting layer B-EML2 of the green organic light emitting device 220 decreases, the thickness of the second electron blocking layer EBL2 and/or the thickness of the green organic light emitting layer G-EML can be adjusted to increase.

Meanwhile, with reference to FIGS. 33 to 36, a stacked structure for each organic light emitting device having a two-stack structure will be described.

A stacked structure for each organic light emitting device having a two-stack structure (the third embodiment and FIG. 21) has already been described above.

Hereinafter, the main technical features that do not overlap with those of the third embodiment (FIG. 21) will be described in detail.

FIG. 33 is a diagram showing a stacked structure for each organic light emitting device according to an eighth embodiment.

The eighth embodiment is the same as the third embodiment except the electron blocking layers EBL11, EBL12, EBL21 and EBL22 disposed on the blue organic light emitting layer B-EML in the red organic light emitting device 210 and/or the green organic light emitting device 220.

In the eighth embodiment, the same reference numerals are given to components having the same structure, shape and/or function as those in the third embodiment, and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a first electron blocking layer can be provided on the hole transport layer HTL and another electron blocking layer EBL, that is, a second electron blocking layer can be provided below the hole transport layer HTL so that the first electron blocking layer EBL, the hole transport layer HTL and the second electron blocking layer EBL can be configured as a triple layer. Accordingly, each thickness T01, T02 and T03 of the red organic light emitting device 210, the green organic light emitting device 220, and the blue organic light emitting device 230 can be adjusted by the first electron blocking layer EBL, the hole transport layer HTL and the second electron blocking layer EBL.

Referring to FIGS. 1, 3, and 33, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

Each of the red organic light emitting device 210, the green organic light emitting device 220, and the blue organic light emitting device 230 can comprise two blue organic light emitting layers B-EML. One blue organic light emitting layer B-EML, that is, the first blue organic light emitting layer can be disposed adjacent to the first electrode E11, E12, and E13, and another blue organic light emitting layer B-EML, that is, the second blue organic light emitting layer can be disposed adjacent to the second electrode E2.

The red organic light emitting device 210 can comprise two red organic light emitting layers R-EML. One red organic light emitting layer R-EML, that is, the first red organic light emitting layer can be disposed on the first blue organic light emitting layer, and another red organic light emitting layer R-EML, that is, the second red organic light emitting layer can be disposed on the second blue organic light emitting layer. For example, the first red organic light emitting layer can be disposed between the first blue organic light emitting layer and the second blue organic light emitting layer vertically overlapping each other.

The green organic light emitting device 220 can comprise two green organic light emitting layers G-EML. One green organic light emitting layer G-EML, that is, the first green organic light emitting layer, can be disposed on the first blue organic light emitting layer, and another green organic light emitting layer G-EML, that is, the second green organic light emitting layer can be disposed on the second blue organic light emitting layer. For example, the first green organic light emitting layer can be disposed between the first blue organic light emitting layer and the second blue organic light emitting layer vertically overlapping each other.

Meanwhile, the red organic light emitting device 210 can comprise two electron blocking layers EBL11 and EBL21. One electron-blocking layer (EBL11), that is, the first electron-blocking layer, can be disposed between the first blue organic light emitting layer and the first red organic light-emitting layer, and another electron-blocking layer (EBL21, that is, the second electron-blocking layer can be disposed between the second blue organic light-emitting layer and the second red organic light emitting layer. The first electron blocking layer EBL11 can prevent electrons remaining after contributing to light emission of light emission of the first red organic light emitting layer from being supplied to the first blue organic light emitting layer. The second electron blocking layer EBL21 can prevent electrons remaining after contributing to light emission of light emission of the second red organic light emitting layer from being supplied to the second blue organic light emitting layer. Accordingly, only red light can be emitted from the red organic light emitting device 210.

The green organic light emitting device 220 can comprise two electron blocking layers EBL12 and EBL22. One electron blocking layer EBL21, that is, the first electron blocking layer, can be disposed between the first blue organic light emitting layer and the first green organic light emitting layer, and another electron blocking layer (EBL22, that is, the second electron blocking layer can be disposed between the second blue organic light emitting layer and the second green organic light emitting layer. The first electron blocking layer EBL21 can prevent electrons remaining after contributing to light emission of the first green organic light emitting layer from being supplied to the first blue organic light emitting layer. The second electron blocking layer EBL22 can prevent electrons remaining after contributing to light emission of the second green organic light emitting layer from being supplied to the second blue organic light emitting layer. Accordingly, only green light can be emitted from the green organic light emitting device 220.

Meanwhile, the thickness of each of the red organic light emitting device 210, the green organic light emitting device 220, and the blue organic light emitting device 230 can be adjusted to maximize the microcavity through constructive interference. For example, in order to increase the thickness of the red organic light emitting device 210 emitting red light having the largest wavelength, the thicknesses T41 and T51 of each of the two red organic light emitting layers can be increased. For example, in order to reduce the thickness of the blue organic light emitting device 230 emitting blue light having a wavelength smaller than the wavelength of red light, the thicknesses T43 and T53 of each of the two blue organic light emitting layers can be reduced. The wavelength of green light can be smaller than the wavelength of red light and greater than the wavelength of blue light. Accordingly, in the green organic light emitting device 220, the thicknesses T42 and T52 of each of the two green organic light emitting layers can be smaller than the thicknesses T41 and T51 of each of the two red organic light emitting layers and can be greater than the thicknesses T43 and T53 of each of the two blue organic light emitting layers. That is, the thickness T42 of the first green organic light emitting layer can be smaller than the thickness T41 of the first red organic light emitting layer and greater than the thickness T43 of the first blue organic light emitting layer. A thickness T52 of the second green organic light emitting layer can be smaller than a thickness T51 of the second red organic light emitting layer and greater than a thickness T53 of the second blue organic light emitting layer.

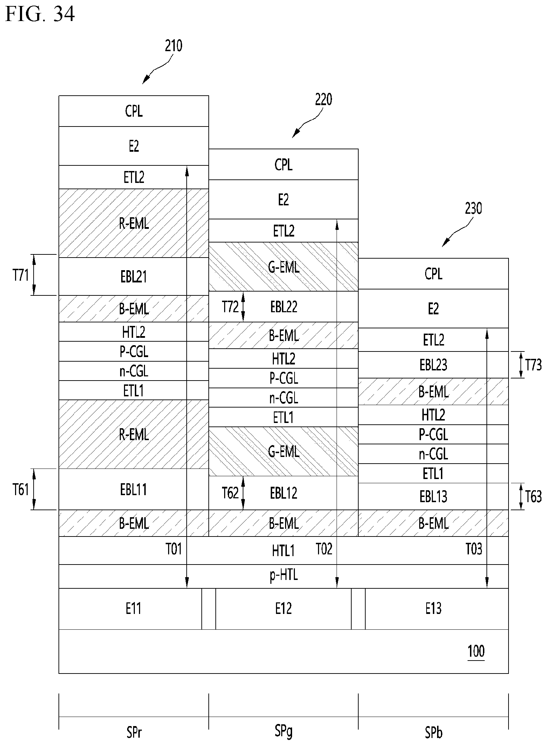

FIG. 34 is a diagram showing a stacked structure for each organic light emitting device according to a nineth embodiment.

The ninth embodiment is the same as the eighth embodiment except that the thickness of the two electron blocking layers EBL11 and EBL21 of the red organic light emitting device 210, the thickness of the two electron blocking layers EBL12 and BLE22 of the green organic light emitting device 220 and the thicknesses of the two electron blocking layers EBL13 and EBL23 of the blue organic light emitting device 230 for constructive interference can be differently adjusted.

In the ninth embodiment, the same reference numerals are given to components having the same structure, shape and/or function as those in the third embodiment or the eighth embodiment, and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a first electron blocking layer can be provided on the hole transport layer HTL and another electron blocking layer EBL, that is, a second electron blocking layer can be provided below the hole transport layer HTL so that the first electron blocking layer EBL, the hole transport layer HTL and the second electron blocking layer EBL can be configured as a triple layer. Accordingly, each thickness T01, T02 and T03 of the red organic light emitting device 210, the green organic light emitting device 220, and the blue organic light emitting device 230 can be adjusted by the first electron blocking layer EBL, the hole transport layer HTL and the second electron blocking layer EBL.

Referring to FIGS. 1, 3, and 34, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

The red organic light emitting device 210 can comprise two electron blocking layers EBL11 and EBL21, the green organic light emitting device 220 can comprise two electron blocking layers EBL12 and EBL22, and the blue organic light emitting device 230 can comprise two electron blocking layers EBL13 and EBL23.

The first electron blocking layer EBL11 of the red organic light emitting device 210, the first electron blocking layer EBL12 of the green organic light emitting device 220, and the first electron blocking layer EBL13 of the blue organic light emitting device 230 can have different thicknesses. For example, the thickness T61 of the first electron blocking layer EBL11 of the red organic light emitting device 210 can be greater than the thickness T62 of the first electron blocking layer EBL12 of the green organic light emitting device 220. For example, the thickness T62 of the first electron blocking layer EBL12 of the green organic light emitting device 220 can be greater than the thickness T63 of the first electron blocking layer EBL13 of the blue organic light emitting device 230.

The second electron blocking layer EBL21 of the red organic light emitting device 210, the second electron blocking layer EBL22 of the green organic light emitting device 220, and the second electron blocking layer EBL23 of the blue organic light emitting device 230 can have different thicknesses. For example, the thickness T71 of the second electron blocking layer EBL21 of the red organic light emitting device 210 can be greater than the thickness T72 of the second electron blocking layer EBL22 of the green organic light emitting device 220. For example, the thickness T72 of the second electron blocking layer EBL22 of the green organic light emitting device 220 can be greater than the thickness T73 of the second electron blocking layer EBL23 of the blue organic light emitting device 230.

As such, the thickness T61 and T71 of the two electron blocking layers EBL11 and EBL21 of the red organic light emitting device 210, the thickness T62 and T72 of the two electron blocking layers EBL12 and BLE22 of the green organic light emitting device 220, and the thickness T63 and T73 of the two electron blocking layers EBL13 and EBL23 of the blue organic light emitting device 230 can be differently adjusted to maximize the microcavity through constructive interference.

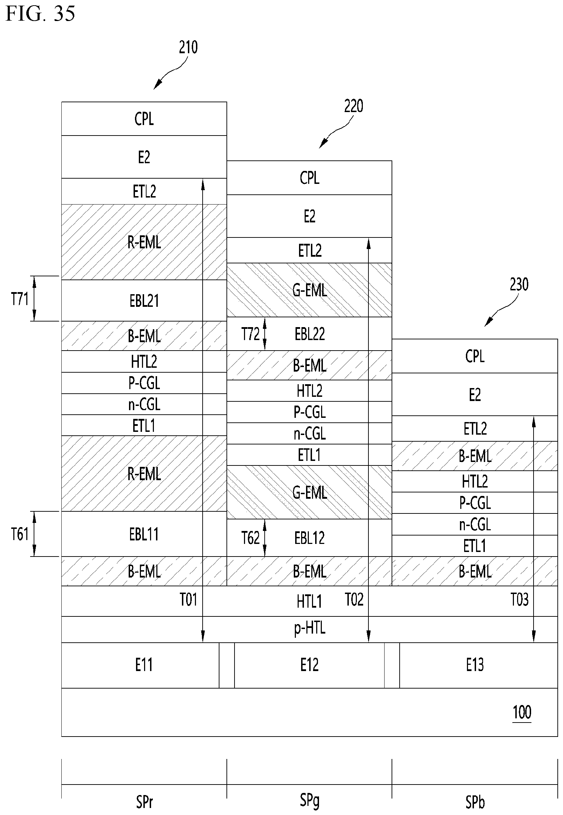

FIG. 35 is a diagram showing a stacked structure for each organic light emitting device according to a tenth embodiment.

The tenth embodiment is the same as the ninth embodiment except that the electron blocking layer is not included in the blue organic light emitting device 230.

In the tenth embodiment, the same reference numerals are given to components having the same structure, shape and/or function as those in the third embodiment, the eighth embodiment or the ninth embodiment, and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a first electron blocking layer can be provided on the hole transport layer HTL and another electron blocking layer EBL, that is, a second electron blocking layer can be provided below the hole transport layer HTL so that the first electron blocking layer EBL, the hole transport layer HTL and the second electron blocking layer EBL can be configured as a triple layer. Accordingly, each thickness T01, T02 and T03 of the red organic light emitting device 210, the green organic light emitting device 220, and the blue organic light emitting device 230 can be adjusted by the first electron blocking layer EBL, the hole transport layer HTL and the second electron blocking layer EBL.

Referring to FIGS. 1, 3, and 35, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

Unlike the ninth embodiment (FIG. 34), in the tenth embodiment, no electron blocking layer can be included in the blue organic light emitting device 230.

Since no electron blocking layer is included in the blue organic light emitting device 230, supply of electrons may not be blocked by the electron blocking layer. Therefore, electrons can be smoothly supplied to the two blue organic light emitting layers without interference, and blue light having a larger amount of light can be emitted from the two blue organic light emitting layers so that the efficiency of the device can be improved. The luminance can be improved by improving the efficiency of the device.

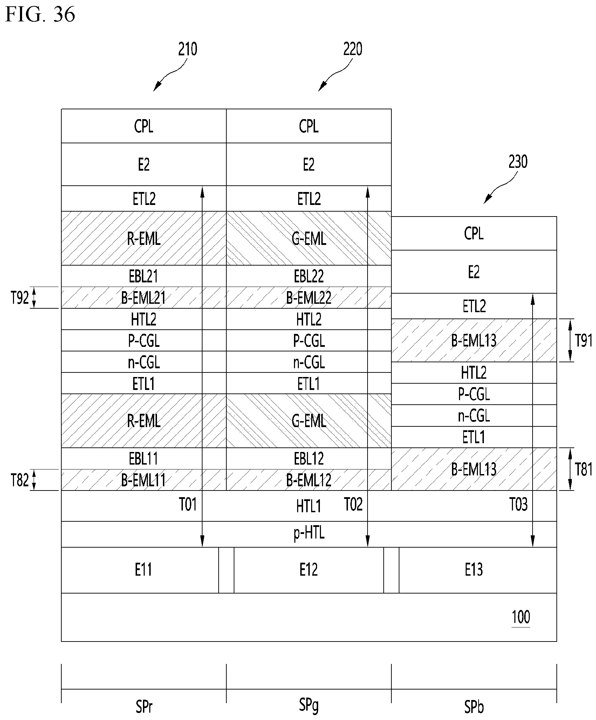

FIG. 36 is a diagram showing a stacked structure for each organic light emitting device according to an eleventh embodiment.

The eleventh embodiment is the same as the tenth embodiment except that each of the two blue organic light emitting layers B-EML11 to B-EML13 and B-EML21 to B-EML13 can have a different thickness for each subpixel SPr, SPg and SPb. In the eleventh embodiment, the same reference numerals are given to components having the same structure, shape and/or function as those in the third embodiment and the eighth to tenth embodiments, and detailed descriptions are omitted. The components omitted below can be easily understood from the foregoing description.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a first electron blocking layer can be provided on the hole transport layer HTL and another electron blocking layer EBL, that is, a second electron blocking layer can be provided below the hole transport layer HTL so that the first electron blocking layer EBL, the hole transport layer HTL and the second electron blocking layer EBL can be configured as a triple layer. Accordingly, each thickness T01, T02 and T03 of the red organic light emitting device 210, the green organic light emitting device 220, and the blue organic light emitting device 230 can be adjusted by the first electron blocking layer EBL, the hole transport layer HTL and the second electron blocking layer EBL.

Referring to FIGS. 1, 3, and 36, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

The red organic light emitting device 210 can comprise two blue organic light emitting layers B-EML11 and B-EML21, and the green organic light emitting device 220 can comprise two blue organic light emitting layers B-EML12 and B-EML22, and the blue organic light emitting device 230 can comprise two blue organic light emitting layers B-EML13 and B-EML23.

The thicknesses T82 and T92 of the two blue organic light emitting layers B-EML11 and B-EML21 in the red organic light emitting device 210 can be smaller than the thicknesses T81 and T91 of the two blue organic light emitting layers B-EML13 and B in the blue organic light emitting device 230, respectively. As the thickness T82 and T92 of each of the two blue organic light emitting layers B-EML11 and B-EML21 in the red organic light emitting device 210 decrease, generation of blue light can be suppressed in each of the blue organic light emitting layers B-EML11 and B-EML21.

The thicknesses T82 and T92 of the two blue organic light emitting layers B-EML12 and B-EML22 in the green organic light emitting device 220 can be smaller than the thicknesses of the two blue organic light emitting layers B-EML13 and EML23 in the blue organic light emitting device 230, respectively. As the thicknesses T82 and T92 of the two blue organic light emitting layers B-EML12 and B-EML22 in the green organic light emitting device 220 decrease, generation of blue light can be suppressed in each of the blue organic light emitting layers B-EML12 and B-EML22.

As such, generation of blue light from the red organic light emitting device 210 or the green organic light emitting device 220 can be suppressed.

Meanwhile, in the blue organic light emitting device 230, the luminance can be increased only when the amount of blue light is large. To this end, the thicknesses T81 and T91 of each of the two blue organic light emitting layers B-EML13 and B-EML23 of the blue organic light emitting device 230 can be large. For example, the thickness T81 of the first blue organic light emitting layer B-EML13 of the blue organic light emitting device 230 can be greater than the thickness T82 of the first blue organic light emitting layer B-EML11 of the red organic light emitting device 210 or the thickness T82 of the first blue organic light emitting layer B-EML12 of the green organic light emitting device 220. For example, the thickness T91 of the second blue organic light emitting layer B-EML23 of the blue organic light emitting device 230 can be greater than the thickness T92 of the second blue organic light emitting layer B-EML21 of the red organic light emitting device 210 or the thickness T92 of the second blue organic light emitting layer B-EML22 of the green organic light emitting device 220.

As such, in the blue organic light emitting device 30, the thicknesses T81 and T91 of the two blue organic light emitting layers B-EML13 and B-EML23 can be set to be large so that efficiency of the device can be improved by increasing the amount of blue light. The luminance can be improved by improving the efficiency of the device.

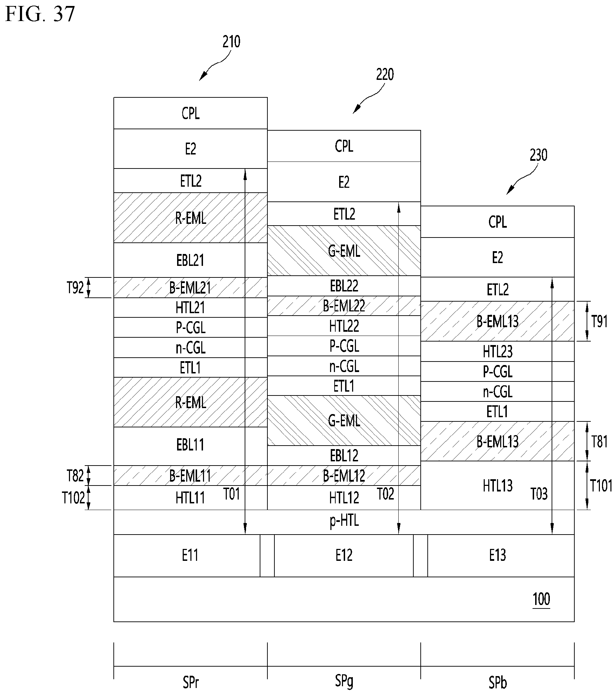

FIG. 37 is a diagram showing a stacked structure for each organic light emitting device according to a twelfth embodiment.

The twelfth embodiment is the same as the eleventh embodiment except that the hole transport layers HT11, HTL12, and HTL13 have different thicknesses and the hole transport layers HT21, HTL22, and HTL23 have different thicknesses for each subpixel SPr, SPg and SPb. It is not shown in FIG. 37 that the hole transport layers HT21, HTL22, and HTL23 have different thicknesses. In the twelfth embodiment, the same reference numerals are given to components having the same structure, shape and/or function as those in the third embodiment and the eighth to tenth embodiments, and detailed descriptions are omitted. The components omitted below can be easily understood from the foregoing description.

In the one-stack structure of the related art, each of the thickness of the red organic light emitting device and the thickness of the green organic light emitting device can be thicker than those of the blue organic light emitting device by utilizing the hole transport layer HTL on the upper hole injection layer p-HTL. To this end, a hole transport layer HTL can be provided with the same thickness, and a hole transport layer HTL having a different thickness can be formed on the red organic light emitting device and the green organic light emitting device using FMM, respectively.

Alternatively, in the related art to which a blue common structure is applied, a hole transport layer HTL can be provided with the same thickness on the hole injection layer p-HTL, and a blue light emitting layer B-EML can be provided with the same thickness on the hole transport layer HTL. A hole transport layer HTL or an electron blocking layer EBL can be formed on the blue light emitting layer B-EML by using the FMM again only on the red organic light emitting device and the green organic light emitting device.

Accordingly, the thickness of each of the red organic light emitting device, the green organic light emitting device, and the blue organic light emitting device 230 can be adjusted.

In addition, in the related art having a two-stack structure, a hole transport layer HTL can be provided with the same thickness on the hole injection layer p-HTL in the one-stack structure of the related art, and a hole transport layer HTL can be not added to each of the red organic light emitting device and the green organic light emitting device. In addition, a hole transport layer for optical distance compensation is not added because the thickness of the first organic light emitting layer and the thickness of the second organic light emitting layer are respectively increased for each stack.

As a result, the first organic light emitting layer R-EML and the second organic light emitting layer G-EML for each stack can be designed to be thicker than the third organic light emitting device to occur optically constructive interference at a thickness of four layers in a two-stack structure or at a thickness of six layers in a three-stack structure. Accordingly, the thickness of each of the red organic light emitting device), the green organic light emitting device, and the blue organic light emitting device can be adjusted.

However, in the twelfth embodiment, the thickness of the hole transport layer HTL11, HTL12 and HTL13 provided on the hole injection layer p-HTL and the thickness of the hole transport layers HTL21, HTL22, and HTL23 provided on the p-type charge generation layer p-CGL of the second stack can be set differently. In addition, contrary to the related art, the thickness of the hole transport layers HTL11 and HTL21 of the red organic light emitting device 210 and the hole transport layers HTL12 and HTL22 of the green organic light emitting device 220 can be provided thinner than the hole transport layer HTL13 and HTL23 of the blue organic light emitting device 230.

In order to further increase the thickness of the thinned device, the thickness of the electron blocking layers EBL11 and EBL21 of the red organic light emitting device and the thickness of the electron blocking layers EBL21 and EBL22 of the green organic light emitting device can be thicker by the amount subtracted by the hole transport layers HTL11, HTL12, HTL12 and HTL22.

As a result, according to the twelfth embodiment, the thicknesses T01, T02 and T03 of the red organic light emitting device 210, the green organic light emitting device 220, and the blue organic light emitting device 230 can be adjusted.

Accordingly, in the twelfth embodiment, the thickness of the third organic light emitting layer B-EML included in each of the red organic light emitting device 210 and the green organic light emitting device 220 can be provided thinner than the thickness of the third organic light emitting layer B-EML included in the blue organic light emitting device 230. In addition, the thickness of the hole transport layers HTL11, HTL12, HTL21 and HTL22 below the third organic light emitting layer B-EML included in each of the red organic light emitting device 210 and the green organic light emitting device 220 can be provided thinner than the thickness of the hole transport layers HTL13 and HTL23 of the blue organic light emitting device 230. Due to the comprehensive, new and innovative structure of the present invention, electrons driven by the voltage at the second electrode, that is, the cathode E2 and the n-type charge generation layer n-CGL of the red organic light emitting device 210 and the green organic light emitting device 220 and flowing to the p-type charge generation layer p-CGL and the first electrode, that is, the anode electrode E11, E12, and E13 can meet holes in the third organic light emitting layer B-EML. However, the probability of light emission by meeting electrons and holes can be extremely low. As a result, the color purity of the first subpixel and the second subpixel can be improved through the twelfth embodiment. In addition, the product with high color gamut can be manufactured.

Although not shown, the hole transport layer HTL can be configured as a double layer of a first hole transport layer HTL1 and a second hole transport layer HTL2, and each thickness T01, T02 and T03 of the red organic light emitting device 210, the green organic light emitting device 220, and the blue organic light emitting device 230 can be adjusted by the first hole transport layer HTL1 and the second hole transport layer HTL2. Although not shown, another electron blocking layer EBL, that is, a first electron blocking layer can be provided on the hole transport layer HTL and another electron blocking layer EBL, that is, a second electron blocking layer can be provided below the hole transport layer HTL so that the first electron blocking layer EBL, the hole transport layer HTL and the second electron blocking layer EBL can be configured as a triple layer. Accordingly, each thickness T01, T02 and T03 of the red organic light emitting device 210, the green organic light emitting device 220, and the blue organic light emitting device 230 can be adjusted by the first electron blocking layer EBL, the hole transport layer HTL and the second electron blocking layer EBL.

Referring to FIGS. 1, 3, and 37, a plurality of stripe patterns STP can be disposed on the substrate 100.

The red organic light emitting device 210 can be disposed on the first inclined surface SS1 of the stripe pattern STP, and the green organic light emitting device 220 can be disposed on the second inclined surface SS2 of the stripe pattern STP. In addition, the blue organic light emitting device 230 can be disposed on a separation area between the adjacent stripe patterns STP.

The red organic light emitting device 210 can comprise two blue organic light emitting layers B-EML11 and B-EML21, and the green organic light emitting device 220 can comprise two blue organic light emitting layers B-EML12 and B-EML22, and the blue organic light emitting device 230 can comprise two blue organic light emitting layers B-EML13 and B-EML23.

The thicknesses T82 and T92 of the two blue organic light emitting layers B-EML11 and B-EML21 in the red organic light emitting device 210 can be smaller than the thickness T81 and T91 of the two blue organic light emitting layers B-EML13 and B-EML23 in the blue organic light emitting device 230, respectively. As the thicknesses T82 and T92 of each of the two blue organic light emitting layers B-EML11 and B-EML21 in the red organic light emitting device 210 decrease, generation of blue light can be suppressed in each of the blue organic light emitting layers B-EML11 and B-EML21.

The thicknesses T82 and T92 of the two blue organic light emitting layers B-EML12 and B-EML22 in the green organic light emitting device 220 can be smaller than the thicknesses T81 and T91 the two blue organic light emitting layers B-EML13 and B-EML23. As the thicknesses T82 and T92 of the two blue organic light emitting layers B-EML12 and B-EML22 in the green organic light emitting device 220 decrease, generation of blue light can be suppressed in each of the blue organic light emitting layers B-EML11 and B-EML21.

As such, generation of blue light from the red organic light emitting device 210 or the green organic light emitting device 220 can be suppressed.

Meanwhile, in the blue organic light emitting device 230, the luminance can be increased only when the amount of blue light is large. To this end, the thicknesses T81 and T91 of each of the two blue organic light emitting layers B-EML13 and B-EML23 of the blue organic light emitting device 30 can be large. For example, the thickness T81 of the first blue organic light emitting layer B-EML13 of the blue organic light emitting device 230 can be greater than the thickness T82 of the first blue organic light emitting layer B-EML11 of the red organic light emitting device 210 or the thickness T82 of the first blue organic light emitting layer B-EML12 of the green organic light emitting device 220. For example, the thickness T91 of the second blue organic light emitting layer B-EML23 of the blue organic light emitting device 230 can be greater than the thickness T92 of the second blue organic light emitting layer B-EML21 of the red organic light emitting device 210 or the thickness T92 of the second blue organic light emitting layer B-EML22 of the green organic light emitting device 220.

As such, in the blue organic light emitting device 30, the thicknesses T81 and T91 of the two blue organic light emitting layers B-EML13 and B-EML23 can be set to be large so that the amount of blue light can be increased to improve the efficiency of the device. The luminance can be improved by improving the efficiency of the device.

Meanwhile, in the twelfth embodiment, the hole transport layers HTL11, HTL12, and HTL13 can have different thicknesses T101 and T101 in the red subpixel SPr, the green subpixel SPg, and the blue subpixel SPb.

For example, the thickness T102 of the hole transport layer HTL11 in the red subpixel SPr can be greater than the thickness T101 of the hole transport layer HTL13 in the blue subpixel SPb. For example, the thickness T102 of the hole transport layer HTL12 in the green subpixel SPg can be greater than the thickness T101 of the hole transport layer HTL13 in the blue subpixel SPb. For example, the thickness T102 of the hole transport layer HTL11 in the red subpixel SPr and the thickness T102 of the hole transport layer HTL12 in the green subpixel SPg can be the same, but are not limited thereto. For example, the thickness T102 of the hole transport layer HTL11 in the red subpixel SPr can be greater than the thickness T102 of the hole transport layer HTL12 in the green subpixel SPg.

Although not shown, the hole transport layer HTL2 positioned between the two blue light emitting organic layers B-EML can have different thicknesses for each of the red subpixel SPr, the green subpixel SPg, and the blue subpixel SPb.

In order to maximize the microcavity through constructive interference, to satisfy Equation 4, the distance d between the first electrode E11, E12, and E13 and the second electrode E2 can be adjusted by at least one organic layer for each of the red subpixel SPr, the green subpixel SPg, and the blue subpixel SPb. For example, the distance d between the first electrode E11, E12, and E13 and the second electrode E2 in the red subpixel SPr can be adjusted by at least one organic layer of the first electron transport layer HTL11, the second electron transport layer HTL, the first blue light emitting layer B-EML11 and the second blue light emitting layer B-EML21. For example, the distance d between the first electrode E11, E12, and E13 and the second electrode E2 in the green subpixel SPg can be adjusted by at least one organic layer of the first electron transport layer HTL12, the second electron transport layer HTL, the first blue light emitting layer B-EML12 and the second blue light emitting layer B-EML22. For example, the distance d between the first electrode E11, E12, and E13 and the second electrode E2 in the blue subpixel SPb can be adjusted by at least one organic layer of the first electron transport layer HTL13, the second electron transport layer HTL, the first blue light emitting layer B-EML13 and the second blue light emitting layer B-EML23.

As described above, the distance d between the first electrode E11, E12, and E13 and the second electrode E2 can be adjusted by at least one organic layer for each of the red subpixel SPr, the green subpixel SPg, and the blue subpixel SPb to satisfy Equation 4. Thus, the microcavity can be maximized through optimal constructive interference, and thus the luminance can be remarkably improved.

In addition, although not shown, the twelfth embodiment can be equally applied to the one-stack structure of the fourth to seventh embodiments of the present invention shown in FIGS. 28 and 30 to 32.

In particular, the self-aligned deposition (SAD) technology of the present invention dramatically expands the degree of freedom in all categories of inventions related to new organic light emitting devices. For example, it is possible to freely adjust the thickness of each of the hole injection layer HIL, the hole transport layer HTL, the electron transport layer ETL, the electron injection layer EIL, the electron blocking layer EBL, and the hole blocking layer HBL, the cathode E2, the charge generation layer (CGL), etc., used as common layers.

The above-described example of device-related implementation can be an example of the invention, and free modification can be possible with respect to the present invention. Accordingly, the present invention can comprise the foregoing embodiments and all technical matters that can be modified from these embodiments, as well as the appended claims.

Meanwhile, in the foregoing embodiments, the case where the in-line deposition apparatus is applied to the organic light emitting display having a stripe pattern has been described. However, the in-line deposition apparatus can be applied to an organic light emitting display having a structure different from a structure having a stripe pattern.

The foregoing embodiment can be an example of the present invention, and free modification can be possible within the scope included in the spirit of the present invention. Accordingly, this invention covers the modifications of this invention within the scope of the appended claims and their equivalents.

**Claims**

1.   An organic light emitting display device, comprising:

   a substrate;
   a plurality of stripe patterns on the substrate;
   a first organic light emitting device in a first subpixel;
   a second organic light emitting device in a second subpixel; and
   a third organic light emitting device in a third subpixel,
   wherein the first organic light emitting device is disposed on a first area of the stripe pattern,
   wherein the second organic light emitting device is disposed on a second area of the stripe pattern, and
   wherein the third organic light emitting device is disposed on a separation area between the adjacent stripe patterns.

2.   The organic light emitting display device of claim 1, wherein

   the first area of the stripe pattern has a first inclined surface inclined with respect to the separation area, and
   the second area of the stripe pattern has a second inclined surface inclined with respect to the separation area.

3.   The organic light emitting display device of claim 2, wherein a first inclined angle of the first inclined surface and a second inclined angle of the second inclined surface are equal to each other.

4.   The organic light emitting display device of claim 2, wherein a first inclined angle of the first inclined surface and a second inclined angle of the second inclined surface are different from each other.

5.   The organic light emitting display device of claim 2, wherein at least one or more of an inclination angle of the first inclined surface and an inclination angle of the second inclined surface is 60 degrees to 95 degrees.

6.   The organic light emitting display device of claim 2, wherein

   the stripe pattern has at least three or more surfaces,
   one of the at least three or more surfaces is the first inclined surface, and

the other surface of the at least three or more surfaces is the second inclined surface.

7. The organic light emitting display device of claim 6, wherein the stripe pattern has a shape symmetrical to each other with respect to the normal direction.

8. The organic light emitting display device of claim 6, wherein the stripe pattern has a shape asymmetrical to each other with respect to the normal direction.

9. The organic light emitting display device of claim 2, wherein each of the first inclined surface and the second inclined surface has a flat or curved shape.

10. The organic light emitting display device of claim 1, wherein each of the first to third organic light emitting devices has a different light emission direction.

11. The organic light emitting display device of claim 1, wherein the first organic light emitting device to the third organic light emitting device commonly comprise a third organic light emitting layer.

12. The organic light emitting display device of claim 11, wherein

the first organic light emitting device comprises a first organic light emitting layer on the third organic light emitting layer, and
the second organic light emitting device comprises a second organic light emitting layer on the third organic light emitting layer.

13. The organic light emitting display device of claim 12, wherein

the first organic light emitting device, the second organic light emitting device, and the third organic light emitting device each comprises a first electrode below the third organic light emitting layer, and
the first electrode is separately disposed in each of the separation area, the first area, and the second area.

14. The organic light emitting display device of claim 13, further comprising:
a protective pattern covering the edge of the first electrode.

15. An organic light emitting display device, comprising:

a substrate;
a plurality of stripe patterns on the substrate;
a first organic light emitting device in a first subpixel;
a second organic light emitting device in a second subpixel; and
a third organic light emitting device in a third subpixel,
wherein the first organic light emitting device is disposed on a first area of the stripe pattern,
wherein the second organic light emitting device is disposed on a second area of the stripe pattern,
wherein the third organic light emitting device is disposed on a separation area between the adjacent stripe patterns,
wherein the first to third organic light emitting devices commonly comprise a third organic light emitting layer,
wherein the first organic light emitting device comprises a first organic light emitting layer on the third organic light emitting layer,
wherein the second organic light emitting device comprises a second organic light emitting layer on the third organic light emitting layer, and
wherein the first organic light emitting layer of the first organic light emitting device, the second organic light emitting layer of the second organic light emitting device, and the third organic light emitting layer of the third organic light emitting device each has a different thickness.

16. The organic light emitting display device of claim 15, wherein

the first organic light emitting device comprises a first electron blocking layer between the first organic light emitting layer and the third organic light emitting layer, and
the second organic light emitting device comprises a second electron blocking layer between the second organic light emitting layer and the third organic light emitting layer.

17. The organic light emitting display device of claim 16, wherein the third organic light emitting device does not comprise a third electron blocking layer on the third organic light emitting layer.

18. The organic light emitting display device of claim 17, wherein the first electron blocking layer to the third electron blocking layer each has a different thickness.

19. The organic light emitting display device of claim 17, wherein the third organic light emitting layer of each of the first to third organic light emitting devices has a different thickness.

20. The organic light emitting display device of claim 19, wherein the thickness of the third organic light emitting layer of the first organic light emitting device is smaller than the thickness of the third organic light emitting layer of the third organic light emitting device.

21. The organic light emitting display device of claim 19, wherein the thickness of the third organic light emitting layer of the second organic light emitting device is smaller than the thickness of the third organic light emitting layer of the third organic light emitting device.

22. The organic light emitting display device of claim 16, wherein the organic light emitting display device satisfies Equation 5 below.

$$\text{Equation 5:} \ | \ \text{EBL T1 - Host T1} \ | \ \geq 0.2 \ \text{eV}$$

EBL T1 represents a triplet energy of a material of the first electron blocking layer in the first organic light emitting device or a triplet energy of a material of the second electron blocking layer in the second organic light emitting device, and
Host T1 represents a triplet energy of a host of the first organic light emitting layer in the first organic light emitting device or a triplet energy of a host of the second organic light emitting layer in the second organic light emitting device.

23. The organic light emitting display device of claim 15, wherein the first organic light emitting device, the second organic light emitting device, and the third organic light emitting device each comprises a first organic light emitting layer and a second organic light emitting layer respectively below and above at least one or more charge generation layer.

24. The organic light emitting display device of claim 23, wherein

the first organic light emitting device, the second organic light emitting device, and the third organic light emitting device comprises a first electron blocking layer below the first organic light emitting layer and a second electron blocking layer between the second organic light emitting layer and the third organic light emitting layer, and
at least one or more of the first electron blocking layer or the second electron blocking layer has a different thickness for each of the first subpixel, the second subpixel, and the third subpixel.

25. The organic light emitting display device of any one of claims 15, 16 and 23, wherein the first organic light emitting device, the second organic light emitting device, and the third organic light emitting device each comprises:

a hole injection layer on a first electrode, a second electrode, and a third electrode; and
a first hole transport layer, a second hole transport layer, and a third hole transport layer on the hole injection layer, respectively,
wherein at least one or more of the first hole transport layer, the second hole transport layer, and the third hole transport layer has a different thickness for each of the first subpixel, the second subpixel, and the third subpixel.

26. The organic light emitting display device of claim 25, wherein the first organic light emitting device, the second organic light emitting device, and the third organic light emitting device each comprises:

a hole injection layer on the first electrode, the second electrode, and the third electrode; and
a first hole transport layer, a second hole transport layer, and a third hole transport layer on the hole injection layer, respectively,
wherein the first hole transport layer and the second hole transport layer have a thickness smaller than that of the third hole transport layer.

FIG. 1

FIG. 2

CPL

E2

EIL/ETL

EML
R-EML | G-EML

B-EML

HTL/HIL

E1

SPr | SPg | SPb

FIG. 3

STP | G-EML | R-EML | TM

B-EML

SS1 | SS2

100

SPr | SPg | SPb

P

FIG. 4

FIG. 5

FIG. 6

FIG. 7

STP

100

B-EML

417

418

415

410

## FIG. 8

## FIG. 9

FIG. 10

FIG. 11

FIG. 12

EP 4 529 400 A1

FIG. 13

(a)

(b)

(c)

FIG. 14

STP

FIG. 15

STP

FIG. 16

STP

FIG. 17

STP

321

SS2

323

321

SS2

323

FIG. 18

| CPL | CPL | |
|---|---|---|
| E2 | E2 | CPL |
| EIL | EIL | E2 |
| ETL | ETL | EIL |
| R-EML | G-EML | ETL |
| B-EML | B-EML | B-EML |
| HTL/HIL | HTL/HIL | HTL/HIL |
| E1 | E1 | E1 |

100

FIG. 19

100 —

CH1:HIL/HTL  CH2:B-EML  CHr1  CH3:G-EML  CH4:R-EML  CHr2  CH5:ETL  CH6:EIL/E2  CH7:CPL

HIL   HTL   410, 415   430, 435   420, 425   410, 415   M1 M2 M3

FIG. 20

| CPL |
| --- |
| E2 |
| ETL |
| HBL |
| R-EML |
| B-EML |
| EBL |
| R-HTL |

| CPL |
| --- |
| E2 |
| ETL |
| HBL |
| G-EML |
| B-EML |
| EBL |
| G-HTL |

| CPL |
| --- |
| E2 |
| ETL |
| HBL |
| B-EML |
| EBL |

| HTL |
| --- |
| p-HTL |

| E1 | E1 | E1 |
| --- | --- | --- |

100

FIG. 21

Column 1 (left stack):
- CPL
- E2
- ETL2
- R-EML
- B-EML
- HCL2
- HTL2
- p-CGL
- n-CGL
- ETL1
- R-EML

Column 2 (middle stack):
- CPL
- E2
- ETL2
- G-EML
- B-EML
- HCL2
- HTL2
- p-CGL
- n-CGL
- ETL1
- G-EML

Column 3 (right stack):
- CPL
- E2
- ETL2
- B-EML
- HCL2
- HTL2
- p-CGL
- n-CGL
- ETL1

Common layers:
- B-EML
- HCL1
- HTL1
- p-HTL
- E1 | E1 | E1

100

FIG. 22

FIG. 23

FIG. 24

FIG. 25

FIG. 26

SPr    SPg    SPb

10

48

38

6

6    6    6    6    18

FIG. 27

FIG. 28

FIG. 29

FIG. 30

FIG. 31

FIG. 32

FIG. 33

FIG. 34

FIG. 35

FIG. 36

FIG. 37

<table>
<tr><td colspan="2">**INTERNATIONAL SEARCH REPORT**</td><td>International application No.<br>**PCT/KR2023/006882**</td></tr>
</table>

**A.    CLASSIFICATION OF SUBJECT MATTER**

**H10K 59/35**(2023.01)i; **H10K 50/814**(2023.01)i; **H10K 50/82**(2023.01)i; **H10K 50/844**(2023.01)i; **H10K 59/124**(2023.01)i; **H10K 59/123**(2023.01)i; **H10K 50/11**(2023.01)i; **H10K 50/13**(2023.01)i; **H10K 71/10**(2023.01)i

According to International Patent Classification (IPC) or to both national classification and IPC

**B.    FIELDS SEARCHED**

Minimum documentation searched (classification system followed by classification symbols)

H10K 59/35(2023.01); H01L 51/50(2006.01); H01L 51/52(2006.01); H04N 13/30(2018.01); H05B 33/22(2006.01); H05B 33/26(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유기발광소자(organic-LED), 표시장치(display), 스트라이프(stripe), 패턴(pattern), 경사면(incline)

**C.    DOCUMENTS CONSIDERED TO BE RELEVANT**

| Category* | Citation of document, with indication, where appropriate, of the relevant passages | Relevant to claim No. |
|---|---|---|
| X<br><br>Y | KR 10-2019-0072821 A (LG DISPLAY CO., LTD.) 26 June 2019 (2019-06-26)<br>  See paragraphs [0005]-[0162]; and figures 3-5. | 1-10<br><br>11-24 |
| Y | KR 10-2015-0043889 A (LG DISPLAY CO., LTD.) 23 April 2015 (2015-04-23)<br>  See paragraphs [0052]-[0071]; and figure 5. | 11-24 |
| Y | KR 10-2010-0048608 A (SAMSUNG ELECTRONICS CO., LTD.) 11 May 2010 (2010-05-11)<br>  See figure 3. | 14 |
| Y | CN 113410405 A (KUNSHAN GOVISIONOX OPTOELECTRONICS CO., LTD. et al.) 17 September 2021 (2021-09-17)<br>  See paragraphs [0049]-[0116]; claim 1; and figure 1. | 16-24 |

☑ Further documents are listed in the continuation of Box C.     ☑ See patent family annex.

| | |
|---|---|
| *    Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **22 August 2023** | **22 August 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/006882** |

**C.     DOCUMENTS CONSIDERED TO BE RELEVANT**

| Category* | Citation of document, with indication, where appropriate, of the relevant passages | Relevant to claim No. |
| --- | --- | --- |
| A | KR 10-2013-0046302 A (LG DISPLAY CO., LTD.) 07 May 2013 (2013-05-07)<br>See entire document. | 1-24 |

Form PCT/ISA/210 (second sheet) (July 2022)

**INTERNATIONAL SEARCH REPORT**

| International application No. |
|---|
| **PCT/KR2023/006882** |

| Box No. II    Observations where certain claims were found unsearchable (Continuation of item 2 of first sheet) |
|---|

This international search report has not been established in respect of certain claims under Article 17(2)(a) for the following reasons:

1. ☐ Claims Nos.:
   because they relate to subject matter not required to be searched by this Authority, namely:

2. ☑ Claims Nos.: **26**
   because they relate to parts of the international application that do not comply with the prescribed requirements to such an extent that no meaningful international search can be carried out, specifically:

   Claim 26 refers to a claim violating the manner of referring to multiple dependent claims (PCT Rule 6.4(a)), and thus is unclear.

3. ☑ Claims Nos.: **25**
   because they are dependent claims and are not drafted in accordance with the second and third sentences of Rule 6.4(a).

Form PCT/ISA/210 (continuation of first sheet) (July 2022)

INTERNATIONAL SEARCH REPORT
Information on patent family members

International application No.

**PCT/KR2023/006882**

| Patent document cited in search report | | | Publication date (day/month/year) | Patent family member(s) | | | Publication date (day/month/year) |
|---|---|---|---|---|---|---|---|
| KR | 10-2019-0072821 | A | 26 June 2019 | CN | 110035272 | A | 19 July 2019 |
| | | | | CN | 110035272 | B | 11 December 2020 |
| | | | | EP | 3499578 | A1 | 19 June 2019 |
| | | | | EP | 3499578 | B1 | 28 October 2020 |
| | | | | KR | 10-2463582 | B1 | 03 November 2022 |
| | | | | US | 10804330 | B2 | 13 October 2020 |
| | | | | US | 2019-0189704 | A1 | 20 June 2019 |
| KR | 10-2015-0043889 | A | 23 April 2015 | KR | 10-2196085 | B1 | 29 December 2020 |
| KR | 10-2010-0048608 | A | 11 May 2010 | US | 2010-0109511 | A1 | 06 May 2010 |
| CN | 113410405 | A | 17 September 2021 | CN | 113410405 | B | 18 April 2023 |
| | | | | KR | 10-2023-0107377 | A | 14 July 2023 |
| | | | | WO | 2023-273479 | A1 | 05 January 2023 |
| KR | 10-2013-0046302 | A | 07 May 2013 | CN | 103094308 | A | 08 May 2013 |
| | | | | CN | 103094308 | B | 02 December 2015 |
| | | | | KR | 10-1818254 | B1 | 15 January 2018 |
| | | | | KR | 10-1818255 | B1 | 15 January 2018 |
| | | | | KR | 10-1818256 | B1 | 15 January 2018 |
| | | | | KR | 10-2013-0046300 | A | 07 May 2013 |
| | | | | KR | 10-2013-0046301 | A | 07 May 2013 |
| | | | | US | 2013-0105773 | A1 | 02 May 2013 |
| | | | | US | 2015-0060834 | A1 | 05 March 2015 |
| | | | | US | 2015-0069369 | A1 | 12 March 2015 |
| | | | | US | 8895967 | B2 | 25 November 2014 |
| | | | | US | 9040979 | B2 | 26 May 2015 |
| | | | | US | 9048204 | B2 | 02 June 2015 |

Form PCT/ISA/210 (patent family annex) (July 2022)